# EUROPEAN PATENT APPLICATION

(11) **EP 2 628 603 A1**
(43) Date of publication of application: **21.08.2013**
(21) Application number: 12836407.2
(22) Date of filing: 10.09.2012
(51) Int. Cl.: B41M 5/00, B41M 5/50, B41M 5/52, C08F 220/12, C09D 133/04, C09D 157/00

(54) **RESIN COMPOSITION FOR FORMING RECEIVING LAYER, RECEIVING SUBSTRATE OBTAINED USING SAME, PRINTED MATTER, CONDUCTIVE PATTERN, AND ELECTRICAL CIRCUIT**

(30) Priority: 30.09.2011 JP 2011216924
(71) Applicant: DIC Corporation, Tokyo 174-8520 (JP)
(72) Inventor: SAITOU Yukie, Takaishi-shi Osaka 592-0001 (JP); FUJIKAWA Wataru, Takaishi-shi Osaka 592-0001 (JP); SHIRAKAMI Jun, Takaishi-shi Osaka 592-0001 (JP)
(74) Representative: Albrecht, Thomas
(86) International application number: PCT/JP2012/073043
(87) International publication number: WO 2013/047167

(57) **Abstract**

It is an object of the present invention to provide a resin composition for forming receiving layers that can form a receiving layer having excellent adhesiveness, has a fine-line-forming property and water resistance even when any of a water-based conductive ink and a solvent-based conductive ink is used, and can form a conductive pattern or the like having wet-heat resistance.

The present invention relates to a resin composition for forming receiving layers that includes a vinyl resin (A) having a weight-average molecular weight of 100,000 or more and an acid value of 10 to 80, a water-based medium (B), and, when necessary, at least one component (C) selected from the group consisting of a water-soluble resin (c1) and a filler (c2), wherein the vinyl resin (A) is dispersed in the water-based medium (B) and a content of the component (C) is 0% by mass to 15% by mass relative to the total amount of the vinyl resin (A).

## Description

### Technical Field

The present invention relates to a resin composition for forming receiving layers that can receive a fluid such as a conductive ink, for example, ejected by a printing method such as an ink-jet printing method, a receiving substrate, and printed matter such as a conductive pattern.

### Background Art

Recently, in the ink-jet printing industry, which has been significantly growing, the realization of high-performance ink-jet printers, the improvement of inks, and the like have markedly progressed, and it has become possible to obtain very fine and sharp images which have excellent printing properties and which are substantially equivalent to film photos even in ordinary households. Therefore, ink-jet printers are not only used in homes but have also started to be used in various industries.

Specifically, it has been studied that such a technique of the ink-jet printing is used when a conductive pattern of an electronic circuit or the like is formed. The reason for this is as follows. In recent years, an increase in performance and a decrease in size and thickness of electronic apparatuses have been demanded, and therefore a decrease in size and thickness of electronic circuits and integrated circuits used in such electronic apparatuses have been strongly demanded. Under such circumstances, an ink-jet printing method is likely to provide a high-density conductive pattern (circuit pattern).

An example of a method for producing a conductive pattern of an electronic circuit or the like using the ink-jet printing technique is a method in which a conductive ink containing a conductive substance such as silver is printed on a substrate by an ink-jet printing technique to form a conductive pattern of an electronic circuit or the like.

However, even when the conductive ink is printed directly on a surface of a support, the conductive ink does not readily adhere to the surface of the support and is easily separated from the support, which may result in, for example, a disconnection in an electronic circuit that is finally obtained. In particular, a support composed of a polyimide resin, a polyethylene terephthalate resin, or the like is relatively flexible and thus receives attention as a support that can be used in the production of flexible devices which can be bent. However, such a support composed of a polyimide resin or the like particularly has poor adhesiveness to inks, resins, and the like and thus inks are easily separated from the support over time. This may result in a disconnection in an electronic circuit that is finally obtained and breaking of electrical connection.

A known method for solving the above problem is a method for forming a conductive pattern by drawing a pattern on an ink-receiving substrate including a latex layer thereon using a conductive ink by a predetermined method. It is known that an acrylic resin can be used for the latex layer (refer to PTL 1).

However, an ink-receiving layer formed of the latex layer on which the conductive pattern is formed may cause bleeding of a conductive ink, unevenness of the printing thickness, and the like. Therefore, it may be difficult to form a conducting line formed of a fine line having a width of about 0.01 to 200 µm, which is generally required for realizing an increase in integration density of electronic circuits or the like.

When the conductive pattern described in PTL 1 is used, for example, in a high-temperature and high-humidity environment of about 85°C x 85 %RH for a long time, dissolution and whitening of a receiving layer and separation from a support are caused. As a result, the electrical conductivity may be decreased and thus such a conductive pattern sometimes does not have wet-heat resistance at such a level that no problems are caused even when the conductive pattern is used for a long time.

In order to achieve a decrease in the width of a line of the conductive pattern, a conductive ink has also been improved. The conductive ink is broadly classified into a water-based conductive ink containing water as a main solvent and a solvent-based conductive ink containing an organic solvent as a main solvent.

However, an ink-receiving layer that is suitable for a particular solvent contained in an ink generally needs to be used. Therefore, if a predetermined conductive ink is printed on a receiving layer that is not suitable for a solvent contained in the predetermined conductive ink, various problems such as bleeding of a conductive pattern are caused.

Specifically, a known receiving layer developed for water-based conductive inks is a receiving layer formed using a water-based resin composition containing, for example, a water-soluble resin, a water-dispersible resin, a compound having two or more silyl groups and two or more secondary amino groups in one molecule, and water. Such a receiving layer generally contains about 50% by mass of a water-soluble resin such as polyvinyl alcohol from the viewpoint of improving the affinity for the water-based conductive ink.

However, the water-soluble resin such as polyvinyl alcohol may increase the hydrophilicity of the receiving layer and considerably decreases the water resistance of the receiving layer. Therefore, when rainwater or the like adheres to a surface of the receiving layer, dissolution and swelling occurs. As a result, bleeding of a conductive pattern formed using the water-based conductive ink, detachment of the conductive substance, and the like are caused and thus the water resistance is not sufficiently achieved.

When the conductive pattern including the receiving layer formed using the water-soluble resin is used, for example, in a high-temperature and high-humidity environment of about 85°C x 85 %RH for a long time, dissolution and whitening of a receiving layer and separation from a support are caused. As a result, the electrical conductivity may be decreased and thus such a conductive pattern sometimes does not have wet-heat resistance at such a level that no problems are caused even when the conductive pattern is used for a long time.

A known receiving layer developed for the water-based conductive ink is a receiving layer containing about 50% by mass of an inorganic filler such as silica, the receiving layer being generally called a microporous receiving layer.

However, since the microporous receiving layer particularly has poor absorbability of solvent-based conductive inks, it is sometimes difficult to provide the fine-line-forming property to the microporous receiving layer. The microporous receiving layer also generally has poor transparency due to the presence of an inorganic component such as silica, which poses a problem when the microporous receiving layer is used in the production of a conductive pattern of a transparent electrode or the like.

When the conductive pattern including the microporous receiving layer is used, for example, in a high-temperature and high-humidity environment of about 85°C x 85 %RH for a long time, dissolution and whitening of a receiving layer and separation from a support are caused. As a result, the electrical conductivity may be decreased and thus such a conductive pattern sometimes does not have wet-heat resistance at such a level that no problems are caused even when the conductive pattern is used for a long time.

On the other hand, it is known that a solvent-based conductive ink can generally form a conductive pattern that is excellent in terms of water resistance, compared with the water-based conductive ink.

However, the water resistance is not easily achieved only by simply using the solvent-based conductive ink instead of the water-based conductive ink. A receiving substrate including a receiving layer that is suitable for the solvent-based conductive ink needs to be used.

Specifically, such a known receiving layer developed for water-based conductive inks is designed to improve the absorbability of a water-based medium in the water-based conductive ink and to improve the fixability of a conductive substance such as silver. Therefore, there is common general technical knowledge in which, when printing is performed on the known receiving layer developed for water-based conductive inks with the solvent-based conductive ink, the receiving layer cannot efficiently absorb a solvent and thus a conductive pattern having high water resistance cannot be formed.

Accordingly, the receiving layer used needs to be changed each time in accordance with the type of conductive ink used for printing, which may considerably decrease the production efficiency of the conductive pattern.

As described above, the development of a resin composition that can form a receiving layer having an excellent fine-line-forming property, high water resistance, and high wet-heat resistance regardless of the type of solvent in a fluid such as an ink even when the printing is performed using any of a water-based conductive ink and a solvent-based conductive ink has been demanded in the industrial world. However, such a receiving layer has not been discovered so far.

In the formation of the conductive pattern, printed matter obtained by performing printing using a conductive ink is usually baked by heating at a temperature of about 80°C or more in order to provide the electrical conductivity by bringing conductive substances contained in the conductive ink into contact with each other.

However, a receiving layer such as the latex layer described in PTL 1 is, for example, readily degraded by the influence of heat received in the baking step. Thus, in particular, the adhesiveness at the interface between the ink-receiving layer and the support decreases, and separation tends to occur even when a very small force is applied. Furthermore, when the receiving layer is subjected to the baking step, dissolution and whitening of the receiving layer and separation from a support are caused and thus the wet-heat resistance is sometimes not sufficiently achieved. In addition, since the latex layer usually does not have sufficient adhesiveness to the support before the heating in the baking step is performed, the support may be partially separated from the receiving layer before the baking step.

In the formation of the conductive pattern, a plating process is often performed on the surface of the conductive pattern using copper or another metal in order to form a highly reliable wiring pattern having a good electrical conduction property maintained without the occurrence of a disconnection or the like for a long time.

However, chemical agents for plating used in the plating process and chemical agents used in a washing step of the plating process are usually strongly alkaline or acidic, and thus these chemical agents readily cause, for example, separation of the receiving layer and the like from the support. As a result, for example, a disconnection may be caused. Furthermore, dissolution and whitening of the receiving layer and separation from the support may be caused depending on the heating conditions in the plating process and thus the known conductive pattern sometimes does not have sufficient wet-heat resistance.

Accordingly, the conductive pattern described above needs to have durability and wet-heat resistance at such a level that, for example, separation of the receiving layer from the support does not occur even when the conductive pattern is repeatedly immersed in the chemical agent or the like for a long time or even when the conductive pattern is exposed in a high-temperature and high-humidity environment for a long time.

### Citation List

### Patent Literature

PTL 1: Japanese Unexamined Patent Application Publication No. 2009-49124

### Summary of Invention

### Technical Problem

It is an object of the present invention to provide a resin composition for forming receiving layers, the resin composition being capable of forming, among receiving layers that can carry a fluid such as a conductive ink, a receiving layer having excellent adhesiveness to a support and also being capable of forming printed matter such as a conductive pattern that has a fine-line-forming property and water resistance which allow the drawing of a fine line of such a level that high integration density of an electronic circuit or the like can be achieved without causing bleeding of the fluid even when any of a water-based conductive ink and a solvent-based conductive ink is used and that has wet-heat resistance at such a level that dissolution and whitening of a receiving layer over time and separation from a support do not occur even when the conductive pattern is used in a high-temperature and high-humidity environment for a long time.

It is a second object of the present invention to provide a resin composition for forming receiving layers, the resin composition being capable of forming printed matter that has wet-heat resistance at such a level that dissolution and whitening of a receiving layer and separation from a support do not occur even when the printed matter is immersed in a chemical agent for plating in a plating process and that has durability and water resistance at such a level that good electrical conductivity can be maintained.

### Solution to Problem

The inventors of the present invention have conducted investigation on the combination with a filler, a dispersing agent, and the like using the microporous receiving layer as a base. With the above receiving layer, a printed image having acceptable fine-line-forming property and water resistance to a fluid such as a water-based conductive ink can be formed, but the fine-line-forming property and water resistance to a fluid such as a solvent-based conductive ink are sometimes considerably decreased. In general, the microporous receiving layer often contains the filler, which considerably decreases the transparency. This poses a problem when the receiving layer is used for a transparent electrode or the like.

Accordingly, the inventors of the present invention have conducted investigation using a so-called swelling-type receiving layer as a base, which has been often used in the production of ink-jet recording paper or the like, in order to improve the water resistance of a conductive pattern or the like formed using a water-based conductive ink. Specifically, in order to improve the water resistance, they have considered that it is important to reduce the amount of water-soluble resin such as polyvinyl alcohol contained in a known swelling-type receiving layer as much as possible. Based on the consideration, they have conducted the investigation.

However, there is common general technical knowledge in which, if the amount of water-soluble resin such as polyvinyl alcohol generally contained in the swelling-type receiving layer for water-based conductive inks is reduced, it becomes difficult to receive a water-based conductive ink. If the amount of water-soluble resin used is simply reduced, bleeding or the like of a conductive pattern formed using a water-based conductive ink is caused, resulting in difficulty in providing an excellent fine-line-forming property.

Accordingly, the inventors have considered that the reduction in the amount of water-soluble resin used is compensated by setting the acid value of a vinyl resin constituting the resin composition for forming receiving layers to a value slightly lower than a known acid value.

By setting the acid value of the resin composition for forming receiving layers to a value lower than a known acid value, the bleeding or the like of a printed image formed when a water-based conductive ink is used is slightly suppressed. However, it is still difficult to provide a sufficient fine-line-forming property and sufficient water resistance. It is also difficult to provide a sufficient fine-line-forming property when a solvent-based conductive ink is used.

The inventors of the present invention have found that, as a result of investigation that uses, as a base, a resin composition for forming receiving layers having an acid value lower than a known acid value, a resin composition for forming receiving layers containing a vinyl resin having a low acid value and a high molecular weight can form a receiving layer that is capable of forming a printed image having an excellent fine-line-forming property and high water resistance at such a level that bleeding or the like does not occur even when printing is conducted using any of the water-based conductive ink and solvent-based conductive ink and that has wet-heat resistance at such a level that dissolution and whitening of the receiving layer over time and separation from a support do not occur even when the receiving layer is used in a high-temperature and high-humidity environment.

The present invention relates to a resin composition for forming receiving layers that includes a vinyl resin (A) having a weight-average molecular weight of 100,000 or more and an acid value of 10 to 80, a water-based medium (B), and, when necessary, at least one component (C) selected from the group consisting of a water-soluble resin (c1) and a filler (c2), wherein the vinyl resin (A) is dispersed in the water-based medium (B) and a content of the component (C) is 0% by mass to 15% by mass relative to the total amount of the vinyl resin (A).

### Advantageous Effects of Invention

According to the resin composition for forming receiving layers of the present invention, there can be formed a receiving layer that has excellent adhesiveness to various supports, that has a fine-line-forming property which allows the drawing of a fine line of such a level that high integration density of an electronic circuit or the like can be achieved without causing bleeding of a conductive ink even when any of fluids such as a water-based conductive ink and a solvent-based conductive ink is used, and that has wet-heat resistance at such a level that dissolution and whitening of a receiving layer over time and separation from a support do not occur even when the receiving layer is used in a high-temperature and high-humidity environment. Therefore, the resin composition for forming receiving layers can be generally used in new fields such as a printed electronics field, for example, in the formation of an electronic circuit using, for example, a conductive ink containing a conductive substance such as silver, the formation of layers and peripheral wiring that are included in an organic solar cell, an electronic book terminal, an organic EL device, an organic transistor, a flexible printed circuit board, RFID such as a non-contact IC card, etc., and the production of wiring of an electromagnetic wave shield, an integrated circuit, and an organic transistor for plasma displays.

Furthermore, by conducting printing on the receiving substrate of the present invention using a fluid such as a conductive ink or a plating nucleus agent and then forming a cross-linked structure in an ink-receiving layer by heating or another process, printed matter (plating structure) having durability that can prevent the detachment of a conductive substance or the like contained in the fluid from a surface of the receiving layer in a plating process performed later can be obtained.

### Description of Embodiments

A resin composition for forming receiving layers according to the present invention includes a vinyl resin (A) having a weight-average molecular weight of 100,000 or more and an acid value of 10 to 80, a water-based medium (B), and, when necessary, at least one component (C) selected from the group consisting of a water-soluble resin (c1) and a filler (c2). The vinyl resin (A) is dispersed in the water-based medium (B) and the content of the component (C) is 0% by mass to 15% by mass relative to the total amount of the vinyl resin (A).

The resin composition for forming receiving layers can be particularly used for forming a receiving layer that absorbs a solvent in a fluid containing a conductive substance or the like and that carries the conductive substance when the fluid contacts the receiving layer.

The vinyl resin (A) contained in the resin composition for forming receiving layers is obtained by polymerizing a monomer having a polymerizable unsaturated double bond, such as a (meth)acrylic monomer or an olefin. Herein, the term "(meth)acrylic" means at least one of "acrylic" and "methacrylic".

A vinyl resin simply having an acid group is not used as the vinyl resin (A). It is important that the vinyl resin (A) satisfies both (1) a weight-average molecular weight of 100,000 or more and (2) a relatively low acid value of 10 to 80 for the purpose of forming printed matter such as a conductive pattern having an excellent fine-line-forming property, high water resistance, and high wet-heat resistance even when printing is performed using any of a water-based conductive ink and a solvent-based conductive ink. In the production of the conductive pattern, the above requirements are particularly important to provide a fine-line-forming property, adhesiveness to a support, and wet-heat resistance.

If a resin composition for forming receiving layers including, instead of the vinyl resin (A), a vinyl resin that satisfies the requirement (1) but has an acid value of more than 80 is used, a receiving layer having high wet-heat resistance sometimes cannot be formed.
The acid value is preferably in the range of 10 to 75, more preferably in the range of 15 to 70, further preferably in the range of 25 to 70, and particularly preferably in the range of 35 to 70 from the viewpoint of providing a better fine-line-forming property, better adhesiveness, and higher wet-heat resistance.

If a resin composition for forming receiving layers including, instead of the vinyl resin (A), a vinyl resin that satisfies the requirement (1) but has an acid value of less than 10 is used, the fine-line-forming property and water resistance of a conductive pattern formed using a water-based conductive ink may be considerably degraded.

The acid value of the vinyl resin (A) is derived from a cross-linkable functional group described below and a hydrophilic group such as an anionic group to be introduced for the purpose of providing good water dispersibility to the vinyl resin (A). Specifically, the acid value is preferably derived from an anionic group such as a carboxyl group, a sulfonic acid group, a carboxylate group, or a sulfonate group. The acid value is more preferably derived from a carboxyl group or a carboxylate group.

Some or all of the carboxyl groups or sulfonic acid groups may be neutralized with a basic compound, e.g., a basic metal compound such as potassium hydroxide or potassium hydroxide, an organic amine such as ammonia, triethylamine, pyridine, or morpholine, or an alkanolamine such as monoethanolamine to form a carboxylate group or a sulfonate group. However, the carboxyl groups or sulfonic acid groups are not necessarily neutralized. In the case where a conductive pattern or the like is formed, the organic amine and alkanolamine are preferably used because the metal salt compound may degrade the electrical conduction property and the like.

The vinyl resin (A) may have the carboxyl group or the like in consideration of good water dispersibility and a good cross-linking property. However, the acid value derived from the carboxyl group or the like is preferably adjusted to be in the range of 10 to 80.

The vinyl resin (A) needs to have a weight-average molecular weight of 100,000 or more and preferably has a weight-average molecular weight of 1,000,000 or more for the purpose of forming a printed image having excellent printing properties, high water resistance, and high wet-heat resistance even when any of a water-based conductive ink and a solvent-based conductive ink is used.

If a resin composition for forming receiving layers including, instead of the vinyl resin (A), a vinyl resin that satisfies the requirement (2) but has a weight-average molecular weight of less than 100,000 is used, the fine-line-forming property and wet-heat resistance of a conductive pattern particularly formed using a solvent-based conductive ink may be considerably degraded.

The upper limit of the weight-average molecular weight of the vinyl resin (A) is not particularly limited, but is preferably about 10,000,000 or less and more preferably 5,000,000 or less. When the conductive pattern or the like is formed, the vinyl resin (A) having the above-described molecular weight is preferably used from the viewpoint of forming a receiving layer for a fluid such as a conductive ink in which bleeding does not occur and which has an excellent fine-line-forming property.

The weight-average molecular weight of the vinyl resin (A) can be generally measured by gel permeation chromatography (GPC) using a sample prepared by mixing 80 mg of the vinyl resin (A) and 20 ml of tetrahydrofuran and stirring the mixed solution for 12 hours. High-performance liquid chromatograph HLC-8220 manufactured by Tosoh Corporation can be used as the measurement instrument. TSKgel GMH XL x 4 column manufactured by Tosoh Corporation can be used as the column. Tetrahydrofuran can be used as the eluent. An RI detector can be used as the detector.

However, if the molecular weight of the vinyl resin (A) is more than 1,000,000, it may be difficult to measure the molecular weight of the vinyl resin (A) by a typical molecular weight measurement method that uses GPC or the like.

Specifically, even after 80 mg of a vinyl resin (A) having a weight-average molecular weight of more than 1,000,000 is mixed with 20 ml of tetrahydrofuran and the mixed solution is stirred for 12 hours, the vinyl resin (A) is not completely dissolved. When the mixed solution is filtered using a membrane filter having a mesh size of 1 µm, a residual substance composed of the vinyl resin (A) may be confirmed on the membrane filter.

Such a residual substance is derived from a vinyl resin having a molecular weight of about more than 1,000,000. Therefore, even if the molecular weight is measured by GPC using a filtrate obtained by the filtration, it may be difficult to measure an accurate weight-average molecular weight of the vinyl resin (A).

In the present invention, when a residual substance is confirmed on the membrane filter as a result of the filtration, such a vinyl resin is determined to have a weight-average molecular weight of more than 1,000,000.

The vinyl resin (A) can be dispersed in a water-based medium (B) described below, and may be partly dissolved in the water-based medium (B).

The vinyl resin (A) may optionally have a functional group. Examples of the functional group include cross-linkable functional groups such as an amide group, a hydroxyl group, a glycidyl group, an amino group, a silyl group, an aziridinyl group, an isocyanate group, an oxazoline group, a cyclopentenyl group, an allyl group, a carboxyl group, and an acetoacetyl group.

When printing is performed on the receiving substrate using a fluid such as a conductive ink and heating or the like is then performed, the cross-linkable functional group undergoes a cross-linking reaction to form a cross-linked structure. Thus, it is possible to form printed matter such as a conductive pattern having high wet-heat resistance and durability at such a level that dissolution, separation, and the like of a receiving layer do not occur even when, for example, a chemical agent for plating or a solvent such as a cleaning agent adheres to the receiving substrate. It is also possible to form printed matter such as a conductive pattern having high wet-heat resistance and durability at such a level that dissolution and whitening of a receiving layer over time and separation from a support do not occur even when the receiving substrate is used in a high-temperature and high-humidity environment for a long time.

The vinyl resin (A) preferably has a glass transition temperature of 1°C to 70°C from the viewpoint of providing, to a printed image, an excellent fine-line-forming property at such a level that bleeding and the like do not occur even when any of a water-based conductive ink and a solvent-based conductive ink is used and particularly providing an excellent fine-line-forming property. Note that the glass transition temperature of the vinyl resin (A) is a value determined by a calculation based on the composition of vinyl monomers used in the production of the vinyl resin (A). Specifically, a vinyl resin (A) having the above predetermined glass transition temperature can be produced by using vinyl monomers in combination as described below.

In addition, a vinyl resin having a glass transition temperature of 10°C to 40°C is preferably used from the viewpoint of providing a good film-forming property when the receiving layer is formed, and providing blocking resistance at such a level that adhesion over time between the receiving layer and the back surface of a support, which is included in the receiving substrate, does not occur when the receiving substrate is wound around a roll or the like or when receiving substrates are stacked.

The vinyl resin (A) can be produced by polymerizing a vinyl monomer mixture containing a vinyl monomer having an acid group such as a carboxyl group and optionally other vinyl monomers.

Examples of the vinyl monomer having an acid group that can be used in the production of the vinyl resin (A) include vinyl monomers having a carboxyl group, such as acrylic acid, methacrylic acid, β-carboxyethyl (meth)acrylate, 2-(meth)acryloyl propionic acid, crotonic acid, itaconic acid, maleic acid, fumaric acid, itaconic acid-half ester, maleic acid-half ester, maleic anhydride, and itaconic anhydride; vinyl sulfonic acid, styrene sulfonic acid, and the salts thereof; sulfonic acids having an allyl group and the salts thereof, such as allyl sulfonic acid and 2-methylallyl sulfonic acid; sulfonic acids having a (meth)acrylate group and the salts thereof, such as 2-sulfoethyl (meth)acrylate and 2-sulfopropyl (meth)acrylate; and "ADEKA REASOAP PP-70 and PPE-710" (manufactured by ADEKA Corporation) having a phosphate group. The vinyl monomers having a carboxyl group and the salts thereof are preferably used.

The vinyl monomer having an acid group can be used in such a range that the acid value of the vinyl resin (A) as an end product is adjusted to be 10 to 80. Specifically, the content of the vinyl monomer having an acid group is preferably in the range of 0.2% by mass to 13% by mass, more preferably in the range of 1.5% by mass to 12% by mass, further preferably in the range of 3.5% by mass to 11% by mass, and particularly preferably in the range of more than 5% by mass and 11% by mass or less relative to the total amount of the vinyl monomer mixture. By using a predetermined amount of vinyl monomer having an acid group, high water dispersion stability, wet-heat resistance, and the like can be provided to a vinyl resin (A1) to be obtained.
In the case where the vinyl monomer having an acid group, in particular, the vinyl monomer having a carboxyl group is used in combination with a vinyl monomer having an amide group described below, the mass ratio of the vinyl monomer having an acid group and the vinyl monomer having an amide group relative to the total amount of the vinyl monomer mixture used in the production of the vinyl resin (A) is preferably in the range of more than 5% by mass and 40% by mass or less and more preferably in the range of 6% by mass or more and 35% by mass or less.

The vinyl monomer mixture that can be used in the production of the vinyl resin (A) preferably further contains, for example, other vinyl monomers in addition to the vinyl monomer having an acid group.

Examples of the other vinyl monomers that can be used include (meth)acrylic acid esters such as methyl (meth)acrylate, ethyl (meth)acrylate, n-butyl (meth)acrylate, i-butyl (meth)acrylate, t-butyl (meth)acrylate, 2-ethylhexyl (meth)acrylate, hexyl (meth)acrylate, cyclohexyl (meth)acrylate, octyl (meth)acrylate, nonyl (meth)acrylate, dodecyl (meth)acrylate, stearyl (meth)acrylate, isobornyl (meth)acrylate, dicyclopentanyl (meth)acrylate, phenyl (meth)acrylate, and benzyl (meth)acrylate; and (meth)acrylic acid alkyl esters such as 2,2,2-trifluoroethyl (meth)acrylate, 2,2,3,3-pentafluoropropyl (meth)acrylate, perfluorocyclohexyl (meth)acrylate, 2,2,3,3-tetrafluoropropyl (meth)acrylate, and β-(perfluorooctyl)ethyl (meth)acrylate.

In particular, methyl methacrylate is preferably used in order to enable a fine line having a width of about 0.01 to 200 µm and preferably about 0.01 to 150 µm, which is required for forming a conductive pattern of an electronic circuit or the like, to be printed without causing bleeding (i.e., improving a fine-line-forming property) even when any of a water-based conductive ink and a solvent-based conductive ink is used. In addition, methyl methacrylate is preferably used in order to, for example, provide excellent adhesiveness between the receiving layer and the support and high wet-heat resistance regardless of the influence of heat in a baking step or another step in the formation of a conductive pattern.

A (meth)acrylic acid alkyl ester having an alkyl group with 2 to 12 carbon atoms is preferably used as the (meth)acrylic acid alkyl ester in combination with the methyl (meth)acrylate in order to provide an excellent fine-line-forming property or the like even when any of a water-based conductive ink and a solvent-based conductive ink is used and particularly to provide a fine-line-forming property that enables a fine line having a width of about 0.01 to 200 µm and preferably about 0.01 to 150 µm, which is required for forming a conductive pattern of an electronic circuit or the like, to be printed without causing bleeding when a conductive pattern is formed using a solvent-based conductive ink.

An acrylic acid alkyl ester having an alkyl group with 3 to 8 carbon atoms is more preferably used as the (meth)acrylic acid alkyl ester in order to improve the fine-line-forming property. The (meth)acrylic acid alkyl ester having an alkyl group with 3 to 8 carbon atoms is preferably n-butyl (meth)acrylate because a conductive pattern or the like having an excellent fine-line-forming property can be formed even when any of a water-based conductive ink and a solvent-based conductive ink is used.

The content of the (meth)acrylic acid alkyl ester is preferably in the range of 30% by mass to 95% by mass relative to the total amount of the vinyl monomer mixture. In particular, the content of methyl (meth)acrylate is preferably in the range of 0.01% by mass to 80% by mass and more preferably in the range of 0.1% by mass to 80% by mass relative to the total amount of the vinyl monomer mixture.

The content of the (meth)acrylic acid alkyl ester having an alkyl group with 2 to 12 carbon atoms, such as n-butyl (meth)acrylate, is preferably in the range of 5% by mass to 60% by mass relative to the total amount of the vinyl monomer mixture because a conductive pattern or the like having an excellent fine-line-forming property can be formed even when any of a water-based conductive ink and a solvent-based conductive ink is used.

Examples of the other vinyl monomers that can be used in the production of the vinyl resin (A) include vinyl acetate, vinyl propionate, vinyl butyrate, vinyl versatate, methyl vinyl ether, ethyl vinyl ether, propyl vinyl ether, butyl vinyl ether, amyl vinyl ether, hexyl vinyl ether, (meth)acrylonitrile, styrene, α-methylstyrene, vinyl toluene, vinylanisole, α-halostyrene, vinyl naphthalene, divinylstyrene, isoprene, chloroprene, butadiene, ethylene, tetrafluoroethylene, vinylidene fluoride, N-vinylpyrrolidone, polyethylene glycol mono(meth)acrylate, glycerol mono(meth)acrylate, and the salts thereof.

Vinyl monomers having a cross-linkable functional group can be used as the other vinyl monomers from the viewpoint of introducing, into the vinyl resin (A), the cross-linkable functional group such as at least one amide group selected from the group consisting of a methylolamide group and alkoxymethylamide groups, an amide group other than the above amide groups, a hydroxyl group, a glycidyl group, an amino group, a silyl group, an aziridinyl group, an isocyanate group, an oxazoline group, a cyclopentenyl group, an allyl group, a carbonyl group, or an acetoacetyl group.

Examples of the vinyl monomer having at least one amide group selected from the group consisting of a methylolamide group and alkoxymethylamide groups, the vinyl monomer being capable of being used as the vinyl monomer having a cross-linkable functional group, include N-methylol(meth)acrylamide, N-methoxymethyl(meth)acrylamide, N-methoxyethoxymethyl(meth)acrylamide, N-ethoxymethyl(meth)acrylamide, N-propoxymethyl(meth)acrylamide, N-isopropoxymethyl(meth)acrylamide, N-n-butoxymethyl(meth)acrylamide, N-isobutoxymethyl(meth)acrylamide, N-pentoxymethyl(meth)acrylamide, N-ethoxymethyl-N-methoxymethyl(meth)acrylamide, N,N'-dimethylol(meth)acrylamide, N-ethoxymethyl-N-propoxymethyl(meth)acrylamide, N,N'-dipropoxymethyl(meth)acrylamide, N-butoxymethyl-N-propoxymethyl(meth)acrylamide, N,N-dibutoxymethyl(meth)acrylamide, N-butoxymethyl-N-methoxymethyl(meth)acrylamide, N,N'-dipentoxymethyl(meth)acrylamide, and N-methoxymethyl-N-pentoxymethyl(meth)acrylamide.

Among these, N-n-butoxymethyl(meth)acrylamide and N-isobutoxymethyl(meth)acrylamide are preferably used for the purpose of forming a conductive pattern or the like having an excellent fine-line-forming property and high durability.

Examples of the vinyl monomers having a cross-linkable functional group include, in addition to the vinyl monomers described above, vinyl monomers having an amide group, such as (meth)acrylamide; vinyl monomers having a hydroxyl group, such as 2-hydroxyethyl (meth)acrylate, 2-hydroxypropyl (meth)acrylate, 2-hydroxybutyl (meth)acrylate, 4-hydroxybutyl (meth)acrylate, 6-hydroxyhexyl (meth)acrylate, (4-hydroxymethylcyclohexyl)methyl (meth)acrylate, glycerol (meth)acrylate, polyethylene glycol (meth)acrylate, N-hydroxyethyl(meth)acrylamide, N-hydroxypropyl(meth)acrylamide, and N-hydroxybutylacrylamide; polymerizable monomers having a glycidyl group, such as glycidyl (meth)acrylate and allylglycidyl ether (meth)acrylate; polymerizable monomers having an amino group, such as aminoethyl (meth)acrylate, dimethylaminoethyl (meth)acrylate, N-monoalkylaminoalkyl (meth)acrylate, and N,N-dialkylaminoalkyl (meth)acrylate; polymerizable monomers having a silyl group, such as vinyltrichlorosilane, vinyltrimethoxysilane, vinyltriethoxysilane, vinyltris(β-methoxyethoxy)silane, γ-(meth)acryloxypropyltrimethoxysilane, γ-(meth)acryloxypropyltriethoxysilane, γ-(meth)acryloxypropylmethyldimethoxysilane, γ-(meth)acryloxypropylmethyldiethoxysilane, γ-(meth)acryloxypropyltriisopropoxysilane, N-β-(N-vinylbenzylaminoethyl)-γ-aminopropyltrimethoxysilane, and the hydrochlorides thereof; polymerizable monomers having an aziridinyl group, such as 2-aziridinylethyl (meth)acrylate; polymerizable monomers having an isocyanate group and/or a blocked isocyanate group, such as (meth)acryloyl isocyanate and a phenol or methyl ethyl ketoxime adduct of ethyl (meth)acryloyl isocyanate; polymerizable monomers having an oxazoline group, such as 2-isopropenyl-2-oxazoline and 2-vinyl-2-oxazoline; polymerizable monomers having a cyclopentenyl group, such as dicyclopentenyl (meth)acrylate; polymerizable monomers having an allyl group, such as allyl (meth)acrylate; and polymerizable monomers having a carbonyl group, such as acrolein and diacetone (meth)acrylamide.

Regarding the vinyl monomers having a cross-linkable functional group, as described above, N-butoxymethyl(meth)acrylamide or N-isobutoxymethyl(meth)acrylamide, which undergoes a selfcross-linking reaction by, for example, being heated, is preferably used alone. Alternatively, N-butoxymethyl(meth)acrylamide or N-isobutoxymethyl(meth)acrylamide is preferably used in combination with (meth)acrylamide or a vinyl monomer having a hydroxyl group, such as 2-hydroxyethyl (meth)acrylate.

In the case where a cross-linking agent (D) described below is used, 2-hydroxyethyl (meth)acrylate, 2-hydroxypropyl (meth)acrylate, and 4-hydroxybutyl (meth)acrylate are more preferably used in order to introduce a functional group, e.g., a hydroxyl group or a carboxyl group, which can serve as a cross-linking point with the cross-linking agent (D). The use of the vinyl monomers having a hydroxyl group is preferable in the case where an isocyanate cross-linking agent is used as a cross-linking agent described below.

The content of the vinyl monomer having a cross-linkable functional group is in the range of 0% by mass to 50% by mass relative to the total amount of the vinyl monomer mixture. In the case where the cross-linking agent (D) undergoes a self-cross-linking reaction, the vinyl monomer having a cross-linkable functional group is not necessarily used.

Among the vinyl monomers having a cross-linkable functional group, the content of the vinyl monomer having an amide group is preferably in the range of 0.1% by mass to 50% by mass and more preferably in the range of 1% by mass to 30% by mass relative to the total amount of the vinyl monomer mixture in order to introduce a self-cross-linking reactive methylolamide group or the like. The content of another vinyl monomer having an amide group or another vinyl monomer having a hydroxyl group used in combination with the self-cross-linking reactive methylolamide group is preferably in the range of 0.1% by mass to 30% by mass and more preferably in the range of 1% by mass to 20% by mass relative to the total amount of the vinyl monomers used in the production of the vinyl resin (A).

Among the vinyl monomers having a cross-linkable functional group, the content of the vinyl monomer having a hydroxyl group is preferably in the range of about 0.05% by mass to 50% by mass, more preferably in the range of about 0.05% by mass to 30% by mass, and further preferably in the range of about 0.1% by mass to 10% by mass relative to the total amount of the vinyl monomer mixture, though the content depends on, for example, the type of cross-linking agent (D) that is used in combination.

A method for producing the vinyl resin (A) will now be described.
The vinyl monomer (A) can be produced by polymerizing the vinyl monomer mixture described above by a known method, and is preferably produced by an emulsion polymerization method in order to form a receiving layer capable of forming a conductive pattern or the like that does not have bleeding and that has an excellent fine-line-forming property.

Examples of the emulsion polymerization method that can be used include a method in which water, a vinyl monomer mixture, a polymerization initiator, and as required, a chain transfer agent, an emulsifier, a dispersion stabilizer, etc. are supplied in a reaction vessel at one time, mixed, and polymerized; a monomer-dropping method in which a vinyl monomer mixture is added dropwise into a reaction vessel and polymerized; and a pre-emulsion method in which a mixture prepared by mixing a vinyl monomer mixture, an emulsifier or the like, and water in advance is added dropwise into a reaction vessel and polymerized.

The reaction temperature of the emulsion polymerization method is preferably, for example, about 30°C to 90°C, though it depends on the types of vinyl monomers and polymerization initiator used. The reaction time is preferably, for example, about 1 to 10 hours.

Examples of the polymerization initiator include persulfates such as potassium persulfate, sodium persulfate, and ammonium persulfate; organic peroxides such as benzoyl peroxide, cumene hydroperoxide, and t-butyl hydroperoxide; and hydrogen peroxide. The polymerization can be conducted by radical polymerization using any of these peroxides alone; by using a redox polymerization initiator in which the above peroxide is used in combination with a reducing agent such as ascorbic acid, a metal salt of formaldehyde sulfoxylate, sodium thiosulfate, sodium bisulfite, or ferric chloride; or by using an azo-based initiator such as 4,4'-azobis(4-cyanovaleric acid) or 2,2'-azobis(2-amidinopropane) dihydrochloride. These compounds may be used alone or in combination as a mixture of two or more compounds.

Examples of the emulsifier that can be used in the production of the vinyl resin (A) include anionic surfactants, nonionic surfactants, cationic surfactants, and amphoteric surfactants. Among these, anionic surfactants are preferably used.

Examples of the anionic surfactant include sulfuric acid esters of higher alcohols and the salts thereof, alkylbenzenesulfonic acid salts, polyoxyethylene alkyl phenyl sulfonic acid salts, polyoxyethylene alkyl diphenyl ether sulfonic acid salts, sulfuric acid half ester salts of polyoxyethylene alkyl ethers, alkyl diphenyl ether disulfonic acid salts, and succinic acid dialkyl ester sulfonic acid salts. Examples of the nonionic surfactant that can be used include polyoxyethylene alkyl ethers, polyoxyethylene alkyl phenyl ethers, polyoxyethylene diphenyl ether, polyoxyethylene-polyoxypropylene block copolymers, and acetylenediol-based surfactants.

An example of the cationic surfactant that can be used is an alkyl ammonium salt.

Examples of the amphoteric surfactant that can be used include alkyl (amide) betaines and alkyldimethylamine oxides.

Examples of the emulsifier that can be used include, in addition to the above surfactants, fluorine-based surfactants, silicone-based surfactants, and emulsifiers that are generally referred to as "reactive emulsifiers", each of which has a polymerizable unsaturated group in its molecule.

Examples of the reactive emulsifier that can be used include "LATEMUL S-180" (manufactured by Kao Corporation), "ELEMINOL JS-2" and "ELEMINOL RS-30" (manufactured by Sanyo Chemical Industries, Ltd.), all of which have a sulfonic acid group and a salt thereof; "Aquaron HS-10", "Aquaron HS-20", and "Aquaron KH-1025" (manufactured by Dai-ichi Kogyo Seiyaku Co., Ltd.), "ADEKA REASOAP SE-10" and "ADEKA REASOAP SE-20" (manufactured by ADEKA Corporation), all of which have a sulfate group and a salt thereof; "New Frontier A-229E" (manufactured by Dai-ichi Kogyo Seiyaku Co., Ltd.), which has a phosphate group; and "Aquaron RN-10", "Aquaron RN-20", "Aquaron RN-30", and "Aquaron RN-50" (manufactured by Dai-ichi Kogyo Seiyaku Co., Ltd.), all of which have a nonionic hydrophilic group.

The same as those exemplified as a water-based medium (B) can be used as a water-based medium used in the production of the vinyl resin (A).

An example of the chain transfer agent that can be used in the production of the vinyl resin (A) is lauryl mercaptan. The content of the chain transfer agent is preferably in the range of 0% by mass to 0.15% by mass and more preferably in the range of 0% by mass to 0.08% by mass relative to the total amount of the vinyl monomer mixture from the viewpoint of forming a receiving layer capable of forming a conductive pattern having a better fine-line-forming property even when any of a water-based conductive ink and a solvent-based conductive ink is used.

The content of the vinyl resin (A) obtained by the above method is preferably in the range of 10% by mass to 60% by mass relative to the total amount of the resin composition for forming receiving layers according to the present invention.

The water-based medium (B) used in the production of the resin composition for forming receiving layers will now be described.

The water-based medium (B) is used to disperse the vinyl resin (A) and may be water alone or a mixed solution of water and a water-soluble solvent. Examples of the water-soluble solvent include alcohols such as methanol, ethanol, n-propanol, and iso-propanol; ketones such as acetone and methyl ethyl ketone; polyalkylene glycols such as ethylene glycol, diethylene glycol, and propylene glycol; alkyl ethers of polyalkylene glycols; and lactams such as N-methyl-2-pyrrolidone. In the present invention, water may be used alone, a mixture of water and a water-soluble solvent miscible with water may be used, or a water-soluble solvent miscible with water may be used alone. From the viewpoint of safety and the load on the environment, water alone or a mixture of water and a water-soluble solvent miscible with water is preferable. Water alone is particularly preferable.

The content of the water-based medium (B) is preferably in the range of 40% by mass to 90% by mass and more preferably in the range of 65% by mass to 85% by mass relative to the total amount of the resin composition for forming receiving layers according to the present invention.

The resin composition for forming receiving layers according to the present invention may optionally contain various additives as long as the effects of the present invention are not impaired. For example, additives that have been used in existing resin compositions for forming receiving layers, such as a water-soluble resin (c1) and a filler (c2) can be suitably used. Herein, the content of at least one component (C) selected from the group consisting of the water-soluble resin (c1) and the filler (c2) needs to be in the range of 0% by mass to 15% by mass relative to the total amount of the vinyl resin (A) in order to form a conductive pattern having both high water resistance and an excellent fine-line-forming property at such a level that bleeding or the like does not occur even when any of a water-based conductive ink and a solvent-based conductive ink is used.

Polyvinyl alcohol and polyvinylpyrrolidone, which are typical examples of the water-soluble resin (c1) are particularly used for the purpose of providing printing properties, a fine-line-forming property, and the like for water-based ink. However, the receiving layer for water-based ink cannot sufficiently receive a solvent-based ink and generally causes bleeding of printed images, for example.

The resin composition for forming receiving layers according to the present invention can surprisingly receive a water-based conductive ink and a solvent-based conductive ink even if the water-soluble resin (c1) such as polyvinyl alcohol is not used or a only a minimum amount of water-soluble resin (c1) is used. Thus, a receiving layer having an excellent fine-line-forming property can be formed even when any of the fluids is used.

The content of the water-soluble resin (c1) is preferably in the range of 0% by mass to 15% by mass, more preferably 0% by mass to 10% by mass, further preferably 0% by mass to 5% by mass, and particularly preferably 0% by mass to 0.5% by mass relative to the total amount of the vinyl resin (A1) from the viewpoint of forming a receiving layer having high water resistance and an excellent fine-line-forming property even when any of a water-based conductive ink and a solvent-based conductive ink is used.

Silica, alumina, and starch, which are typical examples of the filler (c2), are generally used in a large amount when a microporous receiving layer is formed. They may be used in a small amount when a swelling-type receiving layer is formed, for the purpose of providing blocking resistance to the receiving layer.

Since the microporous ink receiving layer is also generally designed for either of a water-based conductive ink and a solvent-based conductive ink, it is often difficult to form a printed image having an excellent fine-line-forming property even when any of a water-based conductive ink and a solvent-based conductive ink is used.

The presence of the filler (c2) in the receiving layer degrades the adhesiveness of the receiving layer to a support and also tends to degrade the transparency and flexibility of the receiving layer. Therefore, for example, a film used in new fields such as a printed electronics field sometimes cannot be applied to a flexible substrate.

The resin composition for forming receiving layers according to the present invention can surprisingly receive a water-based conductive ink and a solvent-based conductive ink even if the filler (c2) such as silica is not used or only a minimum amount of filler (c2) is used. Thus, a receiving layer having an excellent fine-line-forming property and high water resistance can be formed even when any of the fluids such as inks is used.

The content of the filler (c2) is preferably 0% by mass to 15% by mass, more preferably 0% by mass to 10% by mass, and particularly preferably 0% by mass to 0.5% by mass relative to the total amount of the vinyl resin (A) from the viewpoint of forming a receiving layer having an excellent fine-line-forming property and high water resistance even when any of a water-based conductive ink and a solvent-based conductive ink is used. In particular, when the resin composition for forming receiving layers is used in the production of a conductive pattern, the content of the filler or the like is preferably within the above range from the viewpoint of preventing the degradation of the adhesiveness of, for example, a film used in new fields such as a printed electronics field to a flexible substrate.

The resin composition for forming receiving layers according to the present invention may optionally contain known additives such as the cross-linking agent (D), a pH adjusting agent, a coating film-forming auxiliary agent, a leveling agent, a thickener, a water-repellent agent, and an antifoaming agent as long as the effects of the present invention are not impaired.

Examples of the cross-linking agent (D) that can be used include a thermal cross-linking agent (d1-1) that reacts at a relatively low temperature of about 25°C or more and less than 100°C and that can form a cross-linked structure, such as a metal chelate compound, a polyamine compound, an aziridine compound, a metal salt compound, or an isocyanate compound; a thermal cross-linking agent (d1-2) that reacts at a relatively high temperature of about 100°C or more and that can form a cross-linked structure, such as at least one selected from the group consisting of melamine compounds, epoxy compounds, oxazoline compounds, carbodiimide compounds, and blocked isocyanate compounds; and photo-cross-linking agents.

In the case where a resin composition for forming receiving layers contains the thermal cross-linking agent (d1-1), for example, the resin composition is applied onto a surface of a support and dried at a relatively low temperature, printing is then conducted using a fluid such as an ink, and the resulting support is then heated to a temperature of less than 100°C to form a cross-linked structure. Thus, it is possible to form a conductive pattern having wet-heat resistance at such a level that dissolution and whitening of a receiving layer over time and separation from a support do not occur even when the receiving substrate is used in a high-temperature and high-humidity environment and durability that can prevent detachment of a conductive substance or the like regardless of the influence of heat or an external force for a long time.

In the case where a resin composition for forming receiving layers contains the thermal cross-linking agent (d1-2), for example, the resin composition is applied onto a surface of a support and dried at a low temperature in the range of room temperature (25°C) to less than about 100°C to produce a receiving substrate in which a cross-linked structure is not formed, printing is then conducted using a fluid such as an ink or the like, and the resulting receiving substrate is then heated to a temperature of 100°C or more and preferably 120°C or more to form a cross-linked structure. Thus, it is possible to form printed matter and a conductive pattern having wet-heat resistance at such a level that dissolution and whitening of a receiving layer over time and separation from a support do not occur even when the receiving substrate is used in a high-temperature and high-humidity environment and durability at such a level that detachment of a conductive substance contained in the fluid such as an ink is not caused regardless of the influence of heat or an external force for a long time.

Examples of the metal chelate compound that can be used as the thermal cross-linking agent (d1-1) include acetylacetone coordination compounds and acetoacetic acid ester coordination compounds of a polyvalent metal such as aluminum, iron, copper, zinc, tin, titanium, nickel, antimony, magnesium, vanadium, chromium, or zirconium. Acetylacetone aluminum, which is an acetylacetone coordination compound of aluminum, is preferably used.

Examples of the polyamine compound that can be used as the thermal cross-linking agent (d1-1) include tertiary amines such as triethylamine, triethylenediamine, and dimethylethanolamine.

Examples of the aziridine compound that can be used as the thermal cross-linking agent (d1-1) include 2,2-bishydroxymethylbutanol-tris[3-(1-aziridinyl)propionate], 1,6-hexamethylenediethyleneurea, and diphenylmethane-bis-4,4'-N,N'-diethyleneurea.

Examples of the metal salt compound that can be used as the thermal cross-linking agent (d1-1) include aluminum-containing compounds such as aluminum sulfate, aluminum alum, aluminum sulfite, aluminum thiosulfate, polyaluminum chloride, aluminum nitrate nonahydrate, and aluminum chloride hexahydrate; and water-soluble metal salts such as titanium tetrachloride, tetraisopropyl titanate, titanium acetylacetonate, and titanium lactate.

Examples of the isocyanate compound that can be used as the thermal cross-linking agent (d1-1) include polyisocyanates such as tolylene diisocyanate, hydrogenated tolylene diisocyanate, triphenylmethane triisocyanate, methylenebis(4-phenylmethane) triisocyanate, isophorone diisocyanate, hexamethylene diisocyanate, and xylylene diisocyanate; isocyanurate-type polyisocyanate compounds obtained using any of these polyisocyanates; adducts composed of any of these polyisocyanates and trimethylolpropane or the like; and polyisocyanate group-containing urethanes obtained by reacting any of these polyisocyanates with a polyol such as trimethylolpropane. Among these, an isocyanurate of hexamethylene diisocyanate, an adduct of hexamethylene diisocyanate and trimethylolpropane or the like, an adduct of tolylene diisocyanate and trimethylolpropane or the like, or an adduct of xylylene diisocyanate and trimethylolpropane or the like is preferably used.

Examples of the melamine compound that can be used as the thermal cross-linking agent (d1-2) include hexamethoxymethylmelamine, hexaethoxymethylmelamine, hexapropoxymethylmelamine, hexabutoxymethylmelamine, hexapentyloxymethylmelamine, hexahexyloxymethylmelamine, and mixed etherified melamines obtained by using two of these melamine compounds in combination. In particular, trimethoxymethylmelamine or hexamethoxymethylmelamine is preferably used. Examples of a commercially available product that can be used include Beckamine M-3, APM, and J-101 (manufactured by DIC Corporation). The melamine compounds can form a cross-linked structure by a self-cross-linking reaction.

In the case where the melamine compounds are used, a catalyst such as an organic amine salt may be used in order to accelerate the self-cross-linking reaction. Examples of a commercially available product that can be used include Catalyst ACX, 376, etc. The content of the catalyst is preferably in the range of about 0.01% by mass to 10% by mass relative to the total amount of the melamine compound.

Examples of the epoxy compound that can be used as the thermal cross-linking agent (d1-2) include polyglycidyl ethers of aliphatic polyhydric alcohols such as ethylene glycol diglycidyl ether, propylene glycol diglycidyl ether, hexamethylene glycol diglycidyl ether, cyclohexanediol diglycidyl ether, glycerin diglycidyl ether, glycerin triglycidyl ether, trimethylolpropane triglycidyl ether, and pentaerythritol tetraglycidyl ether; polyglycidyl ethers of polyalkylene glycols such as polyethylene glycol diglycidyl ether, polypropylene glycol diglycidyl ether, and polytetramethylene glycol diglycidyl ether; polyglycidylamines such as 1,3-bis(N,N'-diglycidylaminoethyl)cyclohexane; polyglycidyl esters of polyvalent carboxylic acids [such as oxalic acid, adipic acid, butanetricarboxylic acid, maleic acid, phthalic acid, terephthalic acid, isophthalic acid, or benzene tricarboxylic acid]; bisphenol A epoxy resins such as a condensate of bisphenol A and epichlorohydrin and an ethylene oxide adduct of a condensate of bisphenol A and epichlorohydrin; phenol novolac resins; and vinyl (co)polymers having an epoxy group in the side chain thereof. Among these, a polyglycidylamine such as 1,3-bis(N,N'-diglycidylaminoethyl)cyclohexane and a polyglycidyl ether of an aliphatic polyhydric alcohol, such as glycerin diglycidyl ether, are preferably used.

Examples of the epoxy compound that can be used include, in addition to the compounds described above, glycidyl group-containing silane compounds such as γ-glycidoxypropyltrimethoxysilane, γ-glycidoxypropyltriethoxysilane, γ-glycidoxypropylmethyldimethoxysilane, γ-glycidoxypropylmethyldiethoxysilane, β-(3,4-epoxycyclohexyl)ethyltrimethoxysilane, β-(3,4-epoxycyclohexyl)ethyltriethoxysilane, β-(3,4-epoxycyclohexyl)ethylmethyldiethoxysilane, and γ-glycidoxypropyltriisopropenyloxysilane.

Examples of the oxazoline compound that can be used as the thermal cross-linking agent (d1-2) include 2,2'-bis-(2-oxazoline), 2,2'-methylene-bis-(2-oxazoline), 2,2'-ethylene-bis-(2-oxazoline), 2,2'-trimethylene-bis-(2-oxazoline), 2,2'-tetramethylene-bis-(2-oxazoline), 2,2'-hexamethylene-bis-(2-oxazoline), 2,2'-octamethylene-bis-(2-oxazoline), 2,2'-ethylene-bis-(4,4'-dimethyl-2-oxazoline), 2,2'-p-phenylene-bis-(2-oxazoline), 2,2'-m-phenylene-bis-(2-oxazoline), 2,2'-m-phenylene-bis-(4,4'-dimethyl-2-oxazoline), bis-(2-oxazolinylcyclohexane)sulfide, and bis-(2-oxazolinylnorbornane)sulfide.

Examples of the oxazoline compound that can be used further include oxazoline group-containing polymers obtained by polymerizing an addition-polymerizable oxazoline described below and, as required, another monomer in combination.

Examples of the addition-polymerizable oxazoline include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-methyl-2-oxazoline, and 2-isopropenyl-3-ethyl-2-oxazoline. These may be used alone or in combination of two or more compounds. Among these, 2-isopropenyl-2-oxazoline is preferably used because it is industrially easily available.

Examples of the carbodiimide compound that can be used as the thermal cross-linking agent (d1-2) include poly[phenylenebis(dimethylmethylene)carbodiimide] and poly(methyl-1,3-phenylenecarbodiimide). Examples of commercially available products that can be used include "Carbodilite V-01", "V-02", "V-03", "V-04", "V-05", and "V-06" (manufactured by Nisshinbo Chemical Inc.) and UCARLINK XL-29SE and XL-29MP (manufactured by Union Carbide Corporation).

Examples of the blocked isocyanate compound that can be used as the thermal cross-linking agent (d1-2) include compounds in which some or all of isocyanate groups in the isocyanate compounds exemplified as the thermal cross-linking agent (d1-1) are blocked by a blocking agent.

Examples of the blocking agent that can be used include phenol, cresol, 2-hydroxypyridine, butyl cellosolve, propylene glycol monomethyl ether, benzyl alcohol, methanol, ethanol, n-butanol, isobutanol, dimethyl malonate, diethyl malonate, methyl acetoacetate, ethyl acetoacetate, acetylacetone, butyl mercaptan, dodecyl mercaptan, acetanilide, acetic acid amide, ε-caprolactam, δ-valerolactam, γ-butyrolactam, succinic acid imide, maleic acid imide, imidazole, 2-methylimidazole, urea, thiourea, ethylene urea, formamide oxime, acetaldoxime, acetone oxime, methyl ethyl ketoxime, methyl isobutyl ketoxime, cyclohexanone oxime, diphenylaniline, aniline, carbazole, ethyleneimine, and polyethyleneimine.

An example of the blocked isocyanate compound that can be used is Elastron BN-69 (manufactured by Dai-ichi Kogyo Seiyaku Co., Ltd.), which is a water-dispersion type commercially available product.

In the case where the cross-linking agent (D) is used, a vinyl resin having a group that can react with the cross-linkable functional group in the cross-linking agent (D) is preferably used as the vinyl resin (A). Specifically, the (blocked) isocyanate compounds, melamine compounds, oxazoline compounds, and carbodiimide compounds are used as the cross-linking agent (d), and a vinyl resin having a hydroxyl group or a carboxyl group is preferably used as the vinyl resin (A).

In general, the content of the cross-linking agent (D) is preferably in the range of 0.01% by mass to 60% by mass and more preferably in the range of 0.1% by mass to 50% by mass relative to the amount of the vinyl resin (A) because a fine-line-forming property that can achieve, for example, high integration density of an electronic circuit or the like is provided without causing bleeding in a printed portion such as a fine line and the adhesiveness between the receiving layer and a support can be improved, though the content of the cross-linking agent (D) varies depending on, for example, the type of cross-linking agent (D).

The content of the melamine compound serving as the cross-linking agent (D) is preferably in the range of 0.1% by mass to 30% by mass, more preferably in the range of 0.1% by mass to 10% by mass, and further preferably in the range of 0.5% by mass to 5% by mass because the melamine compound causes self-condensation reaction.

The cross-linking agent (D) is preferably added in advance to the resin composition for forming receiving layers according to the present invention before the resin composition is applied onto or impregnated into a surface of a support.

The resin composition for forming receiving layers according to the present invention may contain, in addition to the additives described above, solvent-soluble or solvent-dispersible thermosetting resins such as a phenolic resin, a urea resin, a melamine resin, a polyester resin, a polyamide resin, and a urethane resin.

A receiving layer that can be formed by using the resin composition for forming receiving layers is a swelling-type receiving layer in which the vinyl resin (A) is appropriately dissolved in a solvent contained in a fluid such as an ink and absorbs the solvent, and thus a conductive substance such as a metal that is contained in the fluid can be precisely fixed to a surface of the receiving layer. Accordingly, a bleeding-free conductive pattern can be obtained. Furthermore, the resin composition for forming receiving layers according to the present invention can form a transparent receiving layer compared with a known porous receiving layer.

A receiving substrate of the present invention, the receiving substrate being used for receiving the fluid, will now be described.

The receiving substrate (e.g., conductive ink-receiving substrate) of the present invention includes a receiving layer formed by using the resin composition for forming receiving layers on part or the entirety of a surface of a support. The receiving layer may be stacked on the support. Alternatively, part of the receiving layer may be impregnated into the support. The receiving layer may be provided on either one surface or both surfaces of the support, and may be applied onto part or the entirety of the one or two surfaces.

When the fluid contacts the surface of the receiving layer, the receiving layer absorbs a solvent in the fluid and carries a conductive substance on its surface. For example, in the case where a conductive ink is used as the fluid, a conductive pattern having no bleeding or the like can be formed even when any of a water-based conductive ink and a solvent-based conductive ink is used. In the case where a plating nucleus agent is used as the fluid, a laminate in which plating nuclei are uniformly carried on a surface of the receiving layer without unevenness can be formed.

The receiving substrate of the present invention also has excellent printing properties particularly on a conductive ink serving as the fluid and containing a conductive substance. For example, a fine line having a width of about 0.01 to 200 µm and preferably about 0.01 to 150 µm, which is required for forming a conductive pattern of an electronic circuit or the like, can be printed without causing bleeding (fine-line-forming property). Therefore, the receiving substrate of the present invention can be suitably used in, for example, the printed electronics field, such as the formation of an electronic circuit using a silver ink or the like, the formation of layers and peripheral wiring that are included in an organic solar cell, an electronic book terminal, an organic EL device, an organic transistor, a flexible printed circuit board, RFID, etc., and the formation of wiring of an electromagnetic wave shield of plasma displays.

The receiving substrate of the present invention can be produced by applying the resin composition for forming receiving layers onto part or the entirety of one surface or both surfaces of a support or by impregnating the resin composition into part or the entirety of one or two surfaces of a support, and then removing the water-based medium (B) contained in the resin composition for forming conductive receiving layers.

In the production of the conductive pattern, examples of the support suitable for stacking the receiving layer thereon include supports composed of a polyimide resin, a polyamide-imide resin, a polyamide resin, polyethylene terephthalate, polyethylene naphthalate, polycarbonate, acrylonitrile-butadiene-styrene (ABS), an acrylic resin such as polymethyl (meth)acrylate, polyvinylidene fluoride, polyvinyl chloride, polyvinylidene chloride, polyvinyl alcohol, polycarbonate, polyethylene, polypropylene, polyurethane, cellulose nanofibers, silicon, a ceramic, or glass; porous supports composed of any of these; supports composed of a metal such as copper or a steel sheet; and bases composed of synthetic fibers such as a polyester fiber, a polyamide fiber, and an aramid fiber and natural fibers such as cotton and hemp.

Among these, supports composed of a polyimide resin, polyethylene terephthalate, polyethylene naphthalate, glass, cellulose nanofibers, or the like, all of which are often used as a support when a conductive pattern of a circuit board or the like is formed, are preferably used as the above support.

Among the above supports, bases composed of a polyimide resin, polyethylene terephthalate, polyethylene naphthalate, polycarbonate, acrylonitrile-butadiene-styrene (ABS), an acrylic resin, glass, or the like generally have low adhesiveness, and thus a resin or another material often does not readily adhere to the supports.

In the case where the support is used in, for example, an application that requires flexibility, a support that is relatively flexible and that can be bent is preferably used from the viewpoint of providing flexibility to a conductive pattern and obtaining a final product that can be bent. Specifically, for example, a uniaxially stretched film-like or sheet-like support is preferably used.

Examples of the film-like or sheet-like support include a polyethylene terephthalate film, a polyimide film, and a polyethylene naphthalate film.

Known methods can be employed as a method for applying the resin composition for forming receiving layers onto part or the entirety of a surface of the support or impregnating part or the entirety of a surface of the support with the resin composition. Examples of the method include a gravure method, a coating method, a screen method, a roller method, a rotary method, a spray method, and an ink-jet method.

A method for removing a solvent of the water-based medium (B) that may be contained in the resin composition for forming receiving layers according to the present invention after the resin composition is applied onto or impregnated into part or the entirety of a surface of a support is not particularly limited, but a drying method using a dryer is commonly employed. The drying temperature may be set to a temperature in a range in which the solvent can be volatilized and the support is not adversely affected. Specifically, in the case where the thermal cross-linking agent (d1-1) is used, drying is preferably performed at a temperature of about 25°C or more and less than 100°C. In the case where the thermal cross-linking agent (d1-2) is used, drying is preferably performed at a temperature of about 100°C or more and more preferably at a temperature in the range of about 120°C to 300°C. On the other hand, in the case where the thermal cross-linking agent (d1-2) is used, and printing is performed with a fluid such as an ink and a cross-linked structure is then formed, it is preferable to perform drying at a relatively low temperature of about room temperature (25°C) to 100°C so that a cross-linked structure is not formed before the printing.

The amount of the resin composition for forming receiving layers, the resin composition adhering to a surface of the support, is preferably in the range of 0.01 to 20 g/m² in terms of resin solid content with respect to the area of the support in consideration of the amount of solvent contained in a fluid such as a conductive ink, the thickness of a conductive pattern, and the like. The amount of the resin composition adhering to a surface of the support is particularly preferably in the range of 0.02 to 10 g/m² in consideration of a property of absorbing a solvent contained in the fluid and the production cost.

By increasing the amount of the resin composition for forming receiving layers, the resin composition adhering to a surface of the support, the fine-line-forming property of the receiving substrate can be further improved. However, an increase in the amount of the resin composition tends to make the texture of the resulting receiving substrate somewhat hard. Therefore, for example, in the case where good flexibility is required, e.g., in the case of a flexible printed circuit board that can be bent, the amount of the resin composition is preferably a relatively small amount of about 0.1 to 10 g/m². On the other hand, the resin composition may be used in an embodiment in which the amount of the resin composition is a relatively large amount of about 10 to 100 g/m² depending on, for example, the application of the receiving substrate.

The receiving substrate of the present invention produced by the method described above can also be suitably used when a conductive ink is used as the fluid. In particular, the receiving substrate can be suitably used for forming a conductive pattern or the like in, for example, the printed electronics field. More specifically, the receiving substrate can be suitably used as a substrate for forming circuits, the substrate being used in an electronic circuit, an integrated circuit, or the like.

Printing can be performed on the receiving substrate or the substrate for forming circuits by using a conductive ink as the fluid. Specifically, printing is performed on a receiving layer that is included in the receiving substrate with a conductive ink, and a baking step is then performed. Thus, for example, a conductive pattern including a conductive substance composed of a metal such as silver, the conductive substance being contained in the conductive ink, can be formed on the receiving substrate. Alternatively, printing is performed on a receiving layer that is included in the receiving substrate with a plating nucleus agent, and a baking step is then performed. Thus, for example, a conductive pattern on which a conductive substance composed of a metal such as silver serving as a plating nucleus can be formed on the receiving substrate.

The fluid that can be used for printing on the receiving substrate is a liquid or a viscous liquid having a viscosity of 0.1 to 500,000 mPa·s and preferably 0.5 to 10,000 mPa·s measured at about 25°C with a B-type viscometer, and contains a solvent and a conductive substance dispersed in the solvent. For example, in the case where the fluid is printed by an ink-jet printing method, a fluid having a viscosity in the range of 0.5 to 10,000 mPa·s is preferably used. Specific examples of the fluid include printing inks such as a conductive ink and a plating nucleus agent that may be used in a plating process.

For example, an ink containing a conductive substance, a solvent, and as required, an additive such as a dispersing agent can be used as the conductive ink among the above fluids.

Examples of the conductive substance that can be used include transition metals and the compounds thereof. Among these, ionic transition metals are preferably used. For example, transition metals such as copper, silver, gold, nickel, palladium, platinum, and cobalt are preferably used, and silver, gold, copper, and the like are more preferably used because a conductive pattern that has a low electrical resistance and that is highly resistant to corrosion can be formed.

Particulate conductive substances having an average particle diameter of about 1 to 50 nm are preferably used as the conductive substance. Note that the term "average particle diameter" means a center particle diameter (D50) measured with a laser diffraction/scattering particle size distribution analyzer.

The conductive substance such as a metal is preferably contained in the range of 10% by mass to 60% by mass relative to the total amount of the conductive ink.

Various types of organic solvents and aqueous media such as water can be used as the solvent in the conductive ink. The receiving substrate of the present invention can be suitably used in the case where a solvent-based conductive ink is used.

In the present invention, solvent-based conductive inks that mainly contain an organic solvent as the solvent of the conductive ink, water-based conductive inks that mainly contain water as the solvent, and conductive inks that contain both the organic solvent and water can be appropriately selected and used.

Among these, from the viewpoint of improving, for example, the fine-line-forming property and adhesiveness of a conductive pattern or the like to be formed, conductive inks that contain both the organic solvent and water as the solvent of the conductive ink and solvent-based conductive inks that mainly contain an organic solvent as the solvent of the conductive ink are preferably used, and solvent-based conductive inks that mainly contain an organic solvent as the solvent of the conductive ink are more preferably used.

In particular, the receiving layer included in the receiving substrate of the present invention is preferably used in combination with a conductive ink that particularly contains a polar solvent as the organic solvent because bleeding, a decrease in adhesiveness, and the like that may be caused by the polar solvent can be sufficiently prevented and it is possible to realize a fine-line-forming property at such a level that high integration density of electronic circuits or the like can be achieved.

Examples of the solvent that can be used in the solvent-based conductive ink include polar solvents such as alcohol solvents, e.g., methanol, n-propanol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol, terpineol, and dihydroterpineol; glycol solvents, e.g., 2-ethyl-1,3-hexanediol, ethylene glycol, diethylene glycol, triethylene glycol, polyethylene glycol, propylene glycol, dipropylene glycol, 1,2-butanediol, 1,3-butanediol, 1,4-butanediol, and 2,3-butanediol; glycol ether solvents, e.g., ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, ethylene glycol monoethyl ether acetate, ethylene glycol monomethyl ether acetate, ethylene glycol monobutyl ether acetate, diethylene glycol monoethyl ether acetate, diethylene glycol monobutyl ether acetate, diethylene glycol diethyl ether, diethylene glycol dimethyl ether, diethylene glycol dibutyl ether, tetraethylene glycol dimethyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, tripropylene glycol monobutyl ether, propylene glycol monomethyl ether acetate, dipropylene glycol monomethyl ether acetate, propylene glycol diacetate, propylene glycol phenyl ether, and dipropylene glycol dimethyl ether; and glycerol.

Among the polar solvents, hydroxyl group-containing solvents are preferably used from the viewpoint of preventing bleeding of a conductive pattern or the like to improve a fine-line-forming property and preventing detachment of a conductive substance contained in the conductive ink from a surface of the receiving layer.

In the solvent-based conductive ink, ketone solvents such as acetone, cyclohexanone, and methyl ethyl ketone can be used in combination in order to adjust physical properties. Furthermore, non-polar solvents such as ester solvents, e.g., ethyl acetate, butyl acetate, 3-methoxybutyl acetate, and 3-methoxy-3-methyl-butyl acetate; and hydrocarbon solvents such as toluene, in particular, hydrocarbon solvents having 8 or more carbon atoms, e.g., octane, nonane, decane, dodecane, tridecane, tetradecane, cyclooctane, xylene, mesitylene, ethylbenzene, dodecylbenzene, tetralin, trimethylbenzene, and cyclohexane may also be optionally used in combination. Furthermore, solvents such as mineral spirits and solvent naphtha, which are mixed solvents, may also be used in combination.

However, since a receiving layer formed using the resin composition for forming receiving layers according to the present invention is particularly preferably used in combination with a conductive ink containing a polar solvent, the content of the non-polar solvent is preferably 0% by mass to 40% by mass relative to the total amount of solvent contained in the conductive ink.

The same as those exemplified as the water-based medium (B) can be used as the water-based medium that can be used as a solvent of the conductive ink. For example, water alone may be used or a mixed solution of water and a water-soluble solvent may be used. For example, polar solvents such as alcohols, e.g., methyl alcohol, ethyl alcohol, isopropyl alcohol, ethyl carbitol, ethyl cellosolve, and butyl cellosolve; and N-methylpyrrolidone are preferably used as the water-soluble solvent from the viewpoint of preventing bleeding of a conductive pattern or the like to improve a fine-line-forming property and preventing detachment of a conductive substance contained in the conductive ink from a surface of a receiving layer.

The content of the solvent in the conductive ink is preferably in the range of 40% by mass to 90% by mass relative to the total amount of the conductive ink. The content of the polar solvent is preferably in the range of 40% by mass to 100% by mass relative to the total amount of the solvent.

The conductive ink may optionally contain various types of additives in addition to the metal and the solvent.

A dispersing agent can be used as the additive from the viewpoint of, for example, improving dispersibility of the metal in the solvent.

Examples of the dispersing agent that can be used include amine polymer dispersing agents such as polyethyleneimine and polyvinylpyrrolidone; hydrocarbon polymer dispersing agents having carboxylic acid groups in their molecules, such as polyacrylic acid and carboxymethyl cellulose; and polymer dispersing agents having polar groups, such as polyvinyl alcohol, styrene-maleic acid copolymers, olefin-maleic acid copolymers, and copolymers having a polyethyleneimine moiety and a polyethylene oxide moiety in one molecule thereof. Polyvinyl alcohol may be used as a dispersing agent even in the case where a solvent-based conductive ink is used.

Examples of a method for performing printing on the receiving substrate or the like with the conductive ink include plateless printing methods such as an ink-jet printing method and a laser printing method; mimeographic printing methods such as a screen printing method; planographic printing methods such as an off-set printing method; letterpress printing methods such as a flexographic printing method and a letterpress reverse printing method; intaglio printing methods such as a gravure printing method and a gravure off-set printing method; and methods in which the conductive ink is directly or inversely printed on the receiving substrate or the like, such as a spin coating method, a spray coating method, a bar coating method, a die coating method, a slit coating method, a roll coating method, and a dip coating method.

When a fine line having a width of about 0.01 to 150 µm, which is required for achieving high integration density of an electronic circuit or the like, is printed, an ink-jet printing method, a screen printing method, a letterpress reverse printing method, or a gravure off-set printing method is preferably employed.

In the ink-jet printing method, a device that is generally called an ink-jet printer can be used. Specific examples thereof include Konica Minolta EB100 and XY100 (manufactured by Konica Minolta IJ Technologies, Inc.) and Dimatix materials printer DMP-3000 and Dimatix materials printer DMP-2831 (manufactured by FUJI FILM Corporation).

The screen printing method is a method in which a conductive ink is applied onto a surface of the receiving layer by using a mesh-like screen printing plate. Specifically, a conductive pattern having a predetermined pattern shape can be formed by printing a conductive pattern using a metal screen printing plate that is generally called a metal mesh so as to have the predetermined pattern shape.

The letterpress reverse printing method is a method including applying a conductive ink onto a blanket to form a surface coated with the conductive ink and transferring the conductive ink onto the receiving layer.

A silicone blanket composed of silicone is preferably used as the blanket.

First, a conductive ink is applied onto the blanket to form a layer composed of the conductive ink. Next, a letterpress printing plate including a plate corresponding to a predetermined pattern shape, as required, is pressed against the layer composed of the conductive ink, whereby the conductive ink that is in contact with the letterpress printing plate is transferred from the blanket to a surface of the letterpress printing plate.

Subsequently, the blanket is brought into contact with the receiving layer, thereby transferring the conductive ink remaining on the blanket onto a surface of the receiving layer. A conductive pattern having a predetermined pattern can be formed by this method.

The gravure off-set printing method is conducted as follows. For example, a conductive ink is supplied to a groove of an intaglio printing plate having a predetermined pattern shape. A blanket is then pressed against the surface of the intaglio printing plate, thereby transferring the conductive ink onto the blanket. Next, the conductive ink on the blanket is transferred onto the receiving layer.

For example, a gravure plate or a glass intaglio plate formed by etching a glass plate can be used as the intaglio printing plate.

A blanket having a multilayer structure including a silicone rubber layer, a polyethylene terephthalate layer, a sponge-like layer, and the like can be used as the blanket. In general, a blanket wound around a rigid cylinder, which is called a blanket cylinder, is used.

Electrical conductivity can be provided to printed matter, which is produced by performing printing on the receiving substrate by the method described above, by making conductive substances contained in the conductive ink be in close contact with each other and joining the conductive substances to each other.

Examples of the method for joining the conductive substances include baking by heating and light irradiation.

The printed matter produced by performing printing on the receiving substrate by the method described above is preferably baked from the viewpoint of providing electrical conductivity by making metals contained in the conductive ink be in close contact with each other and joining the metals to each other.

The baking is preferably conducted in the range of about 80°C to 300°C for about 2 to 200 minutes. The baking may be conducted in the air. Alternatively, from the viewpoint of preventing oxidation of the metals, part or all of the baking step may be conducted in a reducing atmosphere.

The baking step can be conducted by using, for example, an oven, a hot-air drying furnace, an infrared drying furnace, laser irradiation, flash-lamp irradiation, or microwaves.

In the case where the cross-linking agent (e1-2) is used and a cross-linked structure is formed after printing is performed with a conductive ink or the like, the cross-linked structure is formed after the printing through the baking step. Thus, the durability of printed matter such as a conductive pattern or the like can be improved.

In the case where the cross-linking reaction and the baking step are conducted at the same time, the heating temperature is preferably in the range of about 80°C to 300°C, more preferably about 100°C to 300°C, and particularly preferably about 120°C to 300°C, though the heating temperature depends on the type of cross-linking agent (D) used, the combination of cross-linkable functional groups, and the like. When the support is relatively vulnerable to heat, the upper limit of the temperature is preferably 200°C or less and more preferably 150°C or less.

On the surface of the printed matter obtained through the baking step, a conductive pattern is formed by the metal contained in the conductive ink. This conductive pattern can be used in, for example, a circuit board or an integrated circuit board of an electrical appliance.

A pattern plated with a metal such as copper may be used as the above conductive pattern in order to form a highly reliable wiring pattern having a good electrical conduction property maintained without the occurrence of a disconnection or the like for a long time. Specifically, the conductive pattern is, for example, a pattern including a plating film composed of copper or the like and formed on a surface of a film that is formed using a plating nucleus agent. The conductive pattern is formed by disposing, for example, a receiving layer on part or the entirety of a surface of the support, the receiving layer being formed by using the resin composition for forming receiving layers; carrying a plating nucleus agent on part or the entirety of a surface of the receiving layer; conducting a baking step or the like as required; then conducting an electroless plating process; and conducting an electrolytic plating process as required.

A plating nucleus agent corresponding to the conductive ink exemplified as the fluid can be used as the above plating nucleus agent. For example, a plating nucleus agent in which a plating nucleus, specifically, a conductive substance is dispersed in a solvent can be used.

For example, at least one selected from the metal particles exemplified as a conductive substance that can be used in the conductive ink, oxides of the metals described above, and the metals whose surface is coated with an organic substance can be used as the conductive substance contained in the plating nucleus agent.

Each of the above metal oxides is usually in an inactive (insulating) state. However, activity (electrical conductivity) can be provided by, for example, treating the metal oxide with a reducing agent such as dimethylaminoborane to expose a metal.

Examples of the metals whose surface is coated with an organic substance include metals included in resin particles (organic substance) prepared by an emulsion polymerization method or the like. Each of these surface-coated metals is usually in an inactive (insulating) state. However, activity (electrical conductivity) can be provided by, for example, removing the organic substance using a laser or the like to expose a metal.

The conductive substance contained in the plating nucleus agent preferably has an average particle diameter in the range of about 10 nm to 1 µm.

The same as those exemplified as the solvents such as a water-based medium and an organic solvent that can be used in the conductive ink can be used as a solvent for the above plating nucleus agent.

The electroless plating process is a process for forming a metal coating film by bringing an electroless plating solution into contact with a surface of a receiving substrate, the surface carrying plating nuclei composed of, for example, palladium or silver, to deposit a metal such as copper contained in the electroless plating solution.

For example, a solution containing a conductive substance composed of a metal such as copper, nickel, chromium, cobalt, or tin, a reducing agent, and a water-based medium can be used as the above electroless plating solution.

Examples of the reducing agent that can be used include dimethylaminoborane, hypophosphorous acid, sodium hypophosphite, dimethylamine borane, hydrazine, formaldehyde, sodium borohydride, and phenols.

The electroless plating solution may optionally contain complexing agents, for example, organic acids such as monocarboxylic acids, e.g., acetic acid and formic acid; dicarboxylic acids, e.g., malonic acid, succinic acid, adipic acid, maleic acid, and fumaric acid; hydroxycarboxylic acids, e.g., malic acid, lactic acid, glycolic acid, gluconic acid, and citric acid; amino acids, e.g., glycine, alanine, iminodiacetic acid, arginine, aspartic acid, and glutamic acid; and aminopolycarboxylic acids, e.g., iminodiacetic acid, nitrilotriacetic acid, ethylenediaminediacetic acid, ethylenediaminetetraacetic acid, and diethylenetriaminepentaacetic acid; soluble salts (such as sodium salts, potassium salts, and ammonium salts) of any of these organic acids; and amines, e.g., ethylenediamine, diethylenetriamine, and triethylenetetramine.

When the electroless plating solution is brought into contact with the surface of the receiving substrate on which the plating nuclei in the plating nucleus agent are carried, the temperature of the electroless plating solution is preferably in the range of about 20°C to 98°C.

The electrolytic plating process is a process for forming a metal coating film by applying a voltage in a state in which an electrolytic plating solution is brought into contact with a surface of a receiving substrate on which the plating nuclei composed of, for example, palladium or silver are carried to deposit a metal such as copper contained in the electrolytic plating solution on an object to be plated (the surface of the receiving substrate on which the plating nuclei are carried), the object being disposed on the negative electrode.

A solution containing a conductive substance composed of a metal such as copper, nickel, chromium, cobalt, or tin, sulfuric acid or the like, and a water-based medium can be used as the above electrolytic plating solution.

When the electrolytic plating solution is brought into contact with the surface of the receiving substrate on which the plating nuclei in the plating nucleus agent are carried, the temperature of the electrolytic plating solution is preferably in the range of about 20°C to 98°C.

In the electroless plating process or the electrolytic plating process described above, the strongly acidic or strongly basic plating solution described above is often used. Therefore, when a common receiving substrate is used, a receiving layer of the receiving substrate is corroded and often separated from the support.

In contrast, in the case where printing is performed on the receiving substrate of the present invention with a fluid such as a plating nucleus agent and a cross-linked structure in the receiving layer is then formed, the separation of the receiving layer from a support does not occur in the plating process. In particular, even when the support is composed of a polyimide resin or the like, the separation of the receiving layer does not occur. Thus, the receiving substrate of the present invention can be suitably used in the production of the conductive pattern.

The conductive pattern described above can be suitably used in the formation of an electronic circuit using a silver ink or the like, the formation of layers and peripheral wiring that are included in an organic solar cell, an electronic book terminal, an organic EL device, an organic transistor, a flexible printed circuit board, RFID, etc., and the formation of a conducive pattern, more specifically, a circuit board in producing, for example, wiring of an electromagnetic wave shield for plasma displays.

Among conductive patterns obtained by the method described above, a conductive pattern obtained by performing printing with a fluid such as a conductive ink or a plating nucleus agent and then forming a cross-linked structure in a receiving layer can be provided with durability at such a level that a good electrical conduction property can be maintained without causing, for example, separation of the receiving layer from a support even in the case where a plating process is performed. Therefore, the conductive pattern can be suitably used in applications that particularly require durability among the formation of a substrate for forming circuits using a silver ink or the like, the substrate being used in an electronic circuit or an integrated circuit; the formation of layers and peripheral wiring that are included in an organic solar cell, an electronic book terminal, an organic EL device, an organic transistor, a flexible printed circuit board, RFID, etc.; and the formation of wiring of an electromagnetic wave shield for plasma displays. In particular, a conductive pattern obtained through the above-described plating process can be a highly reliable wiring pattern having a good electrical conduction property maintained without the occurrence of a disconnection or the like for a long time. Accordingly, such a conductive pattern is generally called a copper clad laminate (CCL) and can be used in the applications of a flexible printed circuit board (FPC), tape automated bonding (TAB), a chip-on-film (COF), and a printed wiring board (PWB).

### EXAMPLES

The present invention will now be described in detail based on Examples.

### Example 1 <Preparation of resin composition (I-1) for forming receiving layer and preparation of receiving substrate (II-1) using the resin composition>

Into a reaction vessel equipped with a stirrer, a reflux condenser, a nitrogen gas-introducing tube, a thermometer, and dropping funnels, 350 parts by mass of deionized water and 4 parts by mass of LATEMUL E-118B (manufactured by Kao Corporation, active component: 25% by mass) were put, and the temperature was increased to 70°C while blowing nitrogen.

Part (5 parts by mass) of a monomer pre-emulsion prepared by mixing a vinyl monomer mixture containing 55.0 parts by mass of methyl methacrylate, 38.0 parts by mass of n-butyl acrylate, and 7.0 parts by mass of methacrylic acid, 4 parts by mass of Aquaron KH-1025 (manufactured by Dai-ichi Kogyo Seiyaku Co., Ltd., active component: 25% by mass) serving as a reactive emulsifier, and 15 parts by mass of deionized water was inserted into the reaction vessel under stirring. Subsequently, 0.1 parts by mass of potassium persulfate was added thereto, and polymerization was conducted for 60 minutes while the temperature in the reaction vessel was maintained at 70°C.

Next, the rest (114 parts by mass) of the monomer pre-emulsion and 30 parts by mass of an aqueous potassium persulfate solution (active component: 1.0% by mass) were added dropwise over a period of 180 minutes using two separate dropping funnels while the temperature in the reaction vessel was maintained at 70°C. After the completion of the dropwise addition, the resulting mixture was stirred at the same temperature for 60 minutes.

The temperature in the reaction vessel was decreased to 40°C, and deionized water was used so that the non-volatile content became 20.0% by mass. Filtration was performed with a 200-mesh filter cloth. Thus, a resin composition (I-1) for forming receiving layers used in the present invention was prepared.

The above resin composition (I-1) for forming receiving layers was applied onto surfaces of three types of substrates represented by (i) to (iii) below using a bar coater so that the dry film thickness became 3 µm. The resulting substrates were dried at 70°C for three minutes using a hot-air dryer. Thus, three types of receiving substrates (II-1) each including a substrate and a receiving layer formed on the substrate were prepared.

### [Support]

(i) PET; polyethylene terephthalate film (manufactured by Toyobo Co., Ltd., Cosmoshine A4300, thickness: 50 µm)
(ii) PI; Polyimide film (manufactured by Du Pont-Toray Co., Ltd., Kapton 200H, thickness 50 µm)
(iii) GL; glass: glass plate, JIS R3202, thickness 2 mm

### Examples 2 to 6 <Preparation of resin compositions (I-2) to (I-6) for forming receiving layer and preparation of receiving substrates (II-2) to (II-6) using the resin compositions>

Resin compositions (I-2) to (I-6) for forming receiving layers with a non-volatile content of 20% by mass were prepared in the same manner as in Example 1, except that the composition of the vinyl monomer mixture was changed to the corresponding compositions shown in Table 1 below.

Receiving substrates (II-2) to (II-6) were produced in the same manner as in Example 1, except that the resin compositions (I-2) to (I-6) for forming receiving layers were used instead of the resin composition (I-1) for forming receiving layers.

### Example 7 <Preparation of resin composition (1-7) for forming receiving layer and preparation of receiving substrate (II-7) using the resin composition>

Into a reaction vessel equipped with a stirrer, a reflux condenser, a nitrogen gas-introducing tube, a thermometer, and dropping funnels, 350 parts by mass of deionized water and 4 parts by mass of LATEMUL E-118B (manufactured by Kao Corporation, active component: 25% by mass) were put, and the temperature was increased to 70°C while blowing nitrogen.

Part (5 parts by mass) of a monomer pre-emulsion prepared by mixing a vinyl monomer mixture containing 55.0 parts by mass of methyl methacrylate, 38.0 parts by mass of n-butyl acrylate, and 7.0 parts by mass of methacrylic acid, 4 parts by mass of Aquaron KH-1025 (manufactured by Dai-ichi Kogyo Seiyaku Co., Ltd., active component: 25% by mass), and 15 parts by mass of deionized water was inserted into the reaction vessel under stirring. Subsequently, 0.1 parts by mass of potassium persulfate was added thereto, and polymerization was conducted for 60 minutes while the temperature in the reaction vessel was maintained at 70°C.

Next, the rest (114 parts by mass) of the monomer pre-emulsion and 30 parts by mass of an aqueous potassium persulfate solution (active component: 1.0% by mass) were added dropwise over a period of 180 minutes using two separate dropping funnels while the temperature in the reaction vessel was maintained at 70°C. After the completion of the dropwise addition, the resulting mixture was stirred at the same temperature for 60 minutes.

The temperature in the reaction vessel was decreased to 40°C, and deionized water was used so that the non-volatile content became 20.0% by mass. Filtration was performed with a 200-mesh filter cloth. Thus, a resin composition (I-7) for forming receiving layers used in the present invention was prepared.

Subsequently, 100 parts by mass of the above mixture, 0.8 parts by mass (solid content mass ratio 100:3) of a melamine compound [Beckamine M-3 (manufactured by DIC Corporation), non-volatile content 78%], and deionized water were mixed with each other to obtain a resin composition (I-7) for forming receiving layers with a non-volatile content of 20% by mass.

The above resin composition (1-7) for forming receiving layers was applied onto surfaces of three types of substrates represented by (i) to (iii) above using a bar coater so that the dry film thickness became 3 µm. The resulting substrates were dried at 70°C for three minutes using a hot-air dryer. Thus, three types of receiving substrates (II-7) each including a substrate and a receiving layer formed on the substrate were prepared.

### Comparative Example 1 <Preparation of resin composition (I'-1) for forming receiving layer and preparation of receiving substrate (II'-1) using the resin composition>

A 10% by mass aqueous solution of PVA 210 [manufactured by KURARAY CO., LTD., polyvinyl alcohol having a degree of saponification of 87 mol% to 89 mol% and a degree of polymerization of 1000] serving as a water-soluble resin was mixed with the resin composition (1-2) for forming receiving layers obtained in Example 2 at the ratio of resin composition (I-2) for forming receiving layers:PVA 210 = 300:400 (solid content mass ratio 60:40). Thus, a resin composition (I'-1) for forming receiving layers with a non-volatile content of 14% by mass was obtained.

The above resin composition (I'-1) for forming receiving layers was applied onto surfaces of three types of substrates represented by (i) to (iii) above using a bar coater so that the dry film thickness became 3 µm. The resulting substrates were dried at 70°C for three minutes using a hot-air dryer. Thus, three types of receiving substrates (II'-1) each including a substrate and a receiving layer formed on the substrate were prepared.

### Comparative Example 2 <Preparation of resin composition (I'-2) for forming receiving layer and preparation of receiving substrate (II'-2) using the resin composition>

SNOWTEX O [manufactured by Nissan Chemical Industries, Ltd., colloidal silica, SiO₂ 20% aqueous dispersion] serving as a filler was mixed with the resin composition (I-2) for forming receiving layers obtained in Example 2 at the ratio of resin composition (I-2) for forming receiving layers:SNOWTEX C = 300:200 (solid content mass ratio 60:40). Thus, a resin composition (I'-2) for forming receiving layers with a non-volatile content of 20% by mass was obtained.

The above resin composition (I'-2) for forming receiving layers was applied onto surfaces of three types of substrates represented by (i) to (iii) above using a bar coater so that the dry film thickness became 3 µm. The resulting substrates were dried at 70°C for three minutes using a hot-air dryer. Thus, three types of receiving substrates (II'-2) each including a substrate and a receiving layer formed on the substrate were prepared.

### Comparative Examples 3 to 5 <Preparation of resin compositions (I'-3) to (I'-5) for forming receiving layer and preparation of receiving substrates (II'-3) to (II'-5) using the resin compositions>

Resin compositions (I'-3) to (I'-5) for forming receiving layers with a non-volatile content of 20% by mass were prepared in the same manner as in Example 1, except that the composition of the vinyl monomer mixture was changed to the corresponding compositions shown in Table 1 below.

Receiving substrates (II'-3) to (II'-5) were produced in the same manner as in Example 1, except that the resin compositions (I'-3) to (I'-5) for forming receiving layers were used instead of the resin composition (I-1) for forming receiving layers.

**[Table 1]**

| Table 1 | | Example | | | | | | |
|---|---|---|---|---|---|---|---|---|
| | | 1 | 2 | 3 | 4 | 5 | 6 | 7 |
| MMA | parts by mass | 55.0 | 45.0 | 37.0 | 49.0 | 42.0 | 44.95 | 55.0 |
| NBMAM | | - | 15.0 | 15.0 | 15.0 | 15.0 | 15.0 | - |
| BA | | 38.0 | 33.0 | 31.0 | 33.0 | 33.0 | 33.0 | 38.0 |
| MAA | | 7.0 | 7.0 | 7.0 | 3.0 | 10.0 | 7.0 | 7.0 |
| CHMA | | - | - | 10.0 | - | - | - | - |
| L-SH | | - | - | - | - | - | 0.05 | - |
| Acid value Weight-average molecular weight | | 46 > 1,000,000 | 46 > 1,000,000 | 46 > 1,000,000 | 20 > 1,000,000 | 65 > 1,000,000 | 46 720,000 | 46 > 1,000,000 |
| Cross-linking agent 1 | parts by mass | - | - | - | - | - | - | 3.0 |
| Water-soluble resin | | - | - | - | - | - | - | - |
| Filler | | - | - | - | - | - | - | - |
| Component that forms cross-linked structure | | None | NBMAM | NBMAM | NBMAM | NBMAM | NBMAM | Cross-linking agent 1 |

**[Table 2]**

| Table 2 | | Comparative Example | | | | |
|---|---|---|---|---|---|---|
| | | 1 | 2 | 3 | 4 | 5 |
| MMA | parts by mass | 45.0 | 45.0 | 44.0 | 52.9 | 36.0 |
| NBMAM | | 15.0 | 15.0 | 15.0 | 15.0 | 15.0 |
| BA | | 33.0 | 33.0 | 33.0 | 32.0 | 36.0 |
| MAA | | 7.0 | 7.0 | 7.0 | 0.1 | 13.0 |
| CHMA | | - | - | - | - | - |
| L-SH | | - | - | 1.0 | - | - |
| Acid value Weight-average molecular weight | | 28 > 1,000,000 | 28 > 1,000,000 | 46 100,000 | 1 > 1,000,000 | 85 > 1,000,000 |
| Cross-linking agent 1 | parts by mass | - | - | - | - | - |
| Water-soluble resin | | 66.7 | - | - | - | - |
| Filler | | | 66.7 | - | - | - |
| Component that forms cross-linked structure | | NBMAM | NBMAM | NBMAM | NBMAM | NBMAM |

### Description of abbreviations in Tables 1 and 2

MMA: methyl methacrylate
NBMAM: N-n-butoxymethylacrylamide
BA: n-butyl acrylate
MAA: methacrylic acid
AM: acrylamide
CHMA: cyclohexyl methacrylate
L-SH: lauryl mercaptan
Cross-linking agent 1: melamine compound [Beckamine M-3 (manufactured by DIC Corporation), trimethoxymethylmelamine]
Water-soluble resin: PVA 210 [manufactured by KURARAY CO., LTD., polyvinyl alcohol having a degree of saponification of 87 mol% to 89 mol% and a degree of polymerization of 1000]
Filler: SNOWTEX O [manufactured by Nissan Chemical Industries, Ltd., colloidal silica, SiO₂ 20% aqueous dispersion]

### [Method for measuring acid value]

The acid value of a vinyl resin is a value calculated on the basis of the amount of acid group-containing vinyl monomer used relative to the total amount of vinyl monomers used in the production of the vinyl resin. The acid value is determined by [the amount of substance (mol) of acid group in acid group-containing vinyl monomer/the total mass of vinyl monomers] x 56100. Specifically, since 7 parts by mass of methacrylic acid (molecular weight 86.09) having one carboxyl group relative to 100 parts by mass of vinyl monomers in total was used in Example 1, the acid value can be calculated to be [{(7/86.09) x 1}/100] x 56100 = 46.

### [Method for measuring weight-average molecular weight]

A mixture of 80 mg of the vinyl resin (A) and 20 ml of tetrahydrofuran was stirred for 12 hours to prepare a measurement sample. The measurement sample was measured by gel permeation chromatography (GPC). High-performance liquid chromatograph HLC-8220 manufactured by Tosoh Corporation was used as the measurement instrument. TSKgel GMH XL x 4 column manufactured by Tosoh Corporation was used as the column. Tetrahydrofuran was used as the eluent. An RI detector was used as the detector.

In the case where the vinyl resin (A) was not completely dissolved even after 80 mg of the vinyl resin (A) and 20 ml of tetrahydrofuran were mixed with each other and the mixed solution was stirred for 12 hours and a residual substance composed of the vinyl resin (A) was confirmed through visual inspection when the mixed solution was filtered using a membrane filter having a mesh size of 1 µm, such a vinyl resin was determined to have a weight-average molecular weight of more than 1,000,000.

### [Method for evaluating adhesiveness between support and receiving layer]

A cellophane adhesive tape (manufactured by Nichiban Co., Ltd., CT405AP-24, 24 mm) was applied onto a surface (onto a receiving layer) of each receiving substrate by pressing with a finger before printing was conducted. The cellophane adhesive tape was then peeled off in a direction at an angle of 90 degrees with respect to the surface of the receiving layer of the receiving substrate. The adhesive surface of the peeled cellophane adhesive tape was visually observed. The adhesiveness was evaluated on the basis of the presence or absence of a substance adhering to the adhesive surface of the tape.

A receiving substrate in which no receiving layer adhered to the adhesive surface of the peeled cellophane adhesive tape was evaluated as "A". A receiving substrate in which less than about 5% of the area of the receiving layer relative to the adhering area of the adhesive tape was detached from the support and adhered to the adhesive tape was evaluated as "B". A receiving substrate in which about 5% or more and less than 50% of the area of the receiving layer relative to the adhering area of the adhesive tape was detached from the support and adhered to the adhesive tape was evaluated as "C". A receiving substrate in which about 50% or more of the area of the receiving layer relative to the adhering area of the adhesive tape was detached from the support and adhered to the adhesive tape was evaluated as "D".

### [Method for preparing conductive ink serving as fluid]

### [Method for preparing ink]

### [Preparation of nano-silver ink 1 for ink-jet printing]

A solvent-based nano-silver ink 1 for ink-jet printing was prepared by dispersing silver particles having an average particle diameter of 30 nm in a mixed solvent containing 65 parts by mass of diethylene glycol diethyl ether, 18 parts by mass of γ-butyrolactone, 15 parts by mass of tetraethylene glycol dimethyl ether, and 2 parts by mass of tetraethylene glycol monobutyl ether.

### [Preparation of nano-silver ink 2 for ink-jet printing]

A water-based nano-silver ink 2 for ink-jet printing was prepared by dispersing silver particles having an average particle diameter of 30 nm in a mixed solvent containing 45 parts by mass of ethylene glycol and 55 parts by mass of ion exchanged water.

### [Preparation of nano-silver ink 3 for ink-jet printing]

A solvent-based nano-silver ink 2 for ink-jet printing was prepared by dispersing silver particles having an average particle diameter of 30 nm in a solvent composed of tetradodecane.

### [Preparation of silver paste for screen printing]

A silver paste (NPS, manufactured by Harima Chemicals Group, Inc.) was used.

### [Printing by ink-jet printing method]

A straight line having a line width of 100 µm and a film thickness of 0.5 µm was printed on surfaces of the three types of receiving substrates obtained by using the supports (i), (ii), and (iii) so as to have a length of about 1 cm with each of the nano-silver inks 1 to 3 for ink-jet printing using an ink-jet printer (manufactured by Konica Minolta IJ Technologies, Inc., ink-jet testing device EB100, printer head for evaluation: KM512L, the amount of ejection: 42 pL). The receiving substrates were then dried at 150°C for 30 minutes to prepare printed matter (conductive patterns). In the case where the receiving substrates described in Examples 2 to 7 and Comparative Examples 1 to 5 were used, a cross-linked structure was formed in the receiving layers through the drying step at 150°C for 30 minutes after the printing was performed with the conductive inks. Whether the cross-linked structure was formed or not was determined on the basis of "a gel fraction of a conductive-ink-receiving layer formed by being dried at room temperature (23°C) and then heated at 70°C" and "a gel fraction of a conductive-ink-receiving layer formed by being further heated at 150°C", as shown in Tables 3 and 4. Specifically, when the gel fraction of a conductive-ink-receiving layer prepared by being heated at 150°C was increased by 25% by mass or more as compared with the gel fraction of a conductive-ink-receiving layer prepared by being dried at room temperature and then heated at 70°C (non-cross-linked state), it was determined that a cross-linked structure was formed by high-temperature heating.

The gel fraction of a receiving layer formed by being dried at room temperature (23°C) and then heated at 70°C was calculated by a method described below.

A resin composition for forming receiving layers was poured onto a polypropylene film surrounded by thick paper so that a film thickness after drying became 100 µm. The resin composition was dried at a temperature of 23°C and a humidity of 65% for 24 hours, and then heat-treated at 70°C for three minutes to form a receiving layer. The receiving layer was separated from the polypropylene film and then cut to have a size of 3 cm in length and 3 cm in width. This receiving layer was used as a test piece. The mass (X) of the test piece 1 was measured, and the test piece 1 was then immersed in 50 mL of methyl ethyl ketone, the temperature of which was adjusted to 25°C, for 24 hours.

A residue (insoluble component) of the test piece 1 that was not dissolved in methyl ethyl ketone through the immersion was filtered with a 300-mesh wire gauze.

The residue obtained above was dried at 108°C for one hour, and the mass (Y) of the dry residue was measured.

Next, a gel fraction was calculated on the basis of a formula [(Y)/(X)] x 100 using the masses (X) and (Y).

The "gel fraction of a receiving layer formed by being heated at 150°C" was calculated by a method described below.

A resin composition for forming receiving layers was poured onto a polypropylene film surrounded by thick paper so that a film thickness after drying became 100 µm. The resin composition was dried at a temperature of 23°C and a humidity of 65% for 24 hours, and then dried by being heated at 150°C for 30 minutes to form a receiving layer. The receiving layer was separated from the polypropylene film and then cut to have a size of 3 cm in length and 3 cm in width. This receiving layer was used as a test piece 2. The mass (X') of the test piece 2 was measured, and the test piece 2 was then immersed in 50 mL of methyl ethyl ketone, the temperature of which was adjusted to 25°C, for 24 hours.

A residue (insoluble component) of the test piece 2 that was not dissolved in methyl ethyl ketone through the immersion was filtered with a 300-mesh wire gauze.

The residue obtained above was dried at 108°C for one hour, and the mass (Y') of the dry residue was measured.

Next, a gel fraction was calculated on the basis of a formula [(Y')/(X')] x 100 using the masses (X') and (Y').

### [Printing by screen printing method]

A straight line having a line width of 50 µm and a film thickness of 1 µm was printed on surfaces of the three types of receiving substrates obtained by using the supports (i), (ii), and (iii) so as to have a length of about 1 cm with the silver paste for screen printing using a metal-mesh 250 screen printing plate. The receiving substrates were then dried at 150°C for 30 minutes to prepare printed matter (conductive patterns).
Regarding the receiving substrates described in Examples 2 to 7 and Comparative Examples 1 to 5, a cross-linked structure was formed in the receiving layers through the drying step at 150°C for 30 minutes after the printing was performed with the conductive ink. The presence or absence of the cross-lined structure was determined by the same method as that described above.

### [Method for evaluating fine-line-forming property]

The entire printed portion (line portion) formed on the surface of the printed matter (conductive pattern) prepared by the method described above was observed with an optical microscope (digital microscope VHX-100, manufactured by Keyence Corporation) to check the presence or absence of bleeding in the printed portion.

Specifically, in the case where bleeding was not observed on the outer edge of the printed portion (line portion), the boundary between the printed portion and the non-printed portion was clear, and there was no difference in height between the outer edge and a central portion of the line portion and the line portion was flat and smooth as a whole, the printed matter was evaluated as "A". In the case where bleeding was somewhat observed in a small portion of the outer edge of the printed portion (line portion), but the boundary between the printed portion and the non-printed portion was clear and the line portion was flat and smooth as a whole, the printed matter was evaluated as "B". In the case where bleeding was somewhat observed within a region of about 1/3 of the outer edge of the printed portion (line portion) and the boundary between the printed portion and the non-printed portion was partially unclear in the bleeding portion, but the line portion was flat and smooth as a whole and at such a level that the line portion could be used, the printed matter was evaluated as "C". In the case where bleeding was observed within a region of about 1/3 to 1/2 of the outer edge of the printed portion (line portion), the boundary between the printed portion and the non-printed portion was partially unclear in the bleeding portion, and the outer edge and a central portion of the line portion were not flat and smooth, the printed matter was evaluated as "D". In the case where bleeding was observed within a region of about 1/2 or more of the outer edge of the printed portion (line portion), the boundary between the printed portion and the non-printed portion was partially unclear in the bleeding portion, and the outer edge and a central portion of the line portion were not flat and smooth, the printed matter was evaluated as "E".

### [Method for evaluating electrical conduction property]

A rectangular region (area) having a length of 3 cm and a width of 1 cm was printed on surfaces of two types of receiving substrates obtained by using the supports (i) and (ii) so as to have a film thickness of 0.5 µm with the nano-silver ink 1 for ink-jet printing using an ink-jet printer (manufactured by Konica Minolta IJ Technologies, Inc., ink-jet testing device EB100, printer head for evaluation: KM512L, the amount of ejection: 42 pL). The receiving substrates were then dried at 150°C for 30 minutes to prepare printed matter (conductive patterns). In the case where the receiving substrates described in electrical conductivity were used, a cross-linked structure was formed in the ink-receiving layers through the drying step at 150°C for 30 minutes after the printing was performed with the ink.

Furthermore, a rectangular region (area) having a length of 3 cm and a width of 1 cm was printed on surfaces of two types of receiving substrates obtained by using the supports (i) and (ii) so as to have a film thickness of 1 µm using the silver paste for screen printing with a metal-mesh 250 screen printing plate. The receiving substrates were then dried at 150°C for 30 minutes to prepare printed matter (conductive patterns).

The volume resistivity of a rectangular solid printed portion having a length of 3 cm and a width of 1 cm and formed on the surface of the printed matter (conductive pattern) obtained by the method described above was measured using a LORESTA resistivity meter (MCP-T610 manufactured by Mitsubishi Chemical Corporation). Printed matter having a volume resistivity of less than 5 × 10⁻⁶ Ω·cm was evaluated as "A". Printed matter which had a volume resistivity of 5 × 10⁻⁶ Ω·cm or more and less than 9 × 10⁻⁶ Ω·cm and which was at such a level that the printed matter could be satisfactorily used was evaluated as "B". Printed matter which had a volume resistivity of 9 × 10⁻⁶ Ω·cm or more and less than 5 × 10⁻⁵ Ω·cm and which was at such a level that the printed matter could be used was evaluated as "C". Printed matter having a volume resistivity of 5 × 10⁻⁵ Ω·cm or more and less than 9 × 10⁻⁵ Ω·cm was evaluated as "D". Printed matter which had a volume resistivity of 9 × 10⁻⁵ Ω·cm or more and which was difficult to be used in practical applications was evaluated as "E".

### [Method for evaluating water resistance]

A rectangular region (area) having a length of 3 cm and a width of 1 cm was printed on a surface of the receiving substrate obtained by using the support (ii) so as to have a film thickness of 0.5 µm with the nano-silver ink 1 for ink-jet printing using an ink-jet printer (manufactured by Konica Minolta IJ Technologies, Inc., ink-jet testing device EB100, printer head for evaluation: KM512L, the amount of ejection: 42 pL). The receiving substrate was then dried at 150°C for 30 minutes to prepare printed matter (conductive pattern). Regarding the conductive-ink-receiving substrates described in Examples 2 to 7 and Comparative Examples 1 to 5, a cross-linked structure was formed in the receiving layer through the drying step at 150°C for 30 minutes after the printing was performed with the ink.

The printed matter (conductive pattern) was cut to have a size of 3 cm × 3 cm so that both the printed portion and the non-printed portion of the receiving layer could be observed, and the appearance of the printed matter immersed in ion exchanged water adjusted to have 40°C for 24 hours was observed. Specifically, after the immersion, the appearances of the printed portion and receiving layer of the printed matter dried at room temperature were observed through visual inspection. An evaluation of "A" was given when no changes were observed in the appearances. An evaluation of "B" was given when no changes were observed in the printed portion, but whitening was partially observed in the receiving layer at such a level that the printed matter could be used in practical applications. An evaluation of "C" was given when no changes were observed in the printed portion, but substantially the entire receiving layer was subjected to whitening. An evaluation of "D" was given when part of the receiving layer was dissolved and part of the printed portion or the receiving layer was detached from the surface of the support. An evaluation of "E" was given when substantially more than half of the receiving layer was dissolved and more than half of the printed portion or receiving layer was detached from the surface of the support.

### [Method for evaluating wet-heat resistance]

A rectangular region (area) having a length of 3 cm and a width of 1 cm was printed on a surface of the receiving substrate obtained by using the support (ii) so as to have a film thickness of 0.5 µm with the nano-silver ink 1 for ink-jet printing and the nano-silver ink 2 for ink-jet printing using an ink-jet printer (manufactured by Konica Minolta IJ Technologies, Inc., ink-jet testing device EB100, printer head for evaluation: KM512L, the amount of ejection: 42 pL). The receiving substrate was then dried at 150°C for 30 minutes to prepare printed matter (conductive pattern). Regarding the conductive-ink-receiving substrates described in Examples 2 to 7 and Comparative Examples 1 to 5, a cross-linked structure was formed in the receiving layer through the drying step at 150°C for 30 minutes after the printing was performed with the ink.

The printed matter (conductive pattern) was cut to have a size of 3 cm × 3 cm so that both the printed portion and the non-printed portion of the receiving layer could be observed, and the appearance of the printed matter stored in a thermo-hygrostat at 85°C and 85 %RH for 1000 hours was observed. Specifically, after the storage, the appearances of the printed portion and receiving layer of the printed matter dried at room temperature were observed through visual inspection. An evaluation of "A" was given when no changes were observed in the appearances. An evaluation of "B" was given when no changes were observed in the printed portion, but whitening was partially observed in the receiving layer at such a level that the printed matter could be used in practical applications. An evaluation of "C" was given when no changes were observed in the printed portion, but substantially the entire receiving layer was subjected to whitening. An evaluation of "D" was given when part of the receiving layer was dissolved and part of the printed portion or the receiving layer was detached from the surface of the support.

### [Method for evaluating durability after electroless plating process]

A solvent-based plating nucleus agent 1 was prepared by dispersing silver particles (plating nuclei) having an average particle diameter of 30 nm in a mixed solvent containing 65 parts by mass of diethylene glycol diethyl ether, 18 parts by mass of γ-butyrolactone, 15 parts by mass of tetraethylene glycol dimethyl ether, and 2 parts by mass of tetraethylene glycol monobutyl ether.

Solid printing of a square region (area) having a length of 5 cm and a width of 5 cm was conducted on a surface of the receiving substrate obtained by using the support (ii) so as to have a film thickness of 0.5 µm with the plating nucleus agent 1 using an ink-jet printer (manufactured by Konica Minolta IJ Technologies, Inc., ink-jet testing device EB100, printer head for evaluation: KM512L, the amount of ejection: 42 pL). The receiving substrate was then dried at 150°C for 30 minutes to prepare printed matter. Regarding the receiving substrates described in Examples 2 to 7 and Comparative Examples 1 to 5, a cross-linked structure was formed in the receiving layer through the drying step at 150°C for 30 minutes after the printing was performed with the plating nucleus agent 1.

An activating agent (ACE CLEAN A220 manufactured by Okuno Chemical Industries Co., Ltd.) was applied onto the surface (surface on which the plating nuclei were carried) of the printed matter prepared above, and an activating treatment of the plating nuclei was conducted at 55°C for five minutes.

Subsequently, an electroless copper plating solution (OPC-750, manufactured by Okuno Chemical Industries Co., Ltd.) was applied onto the surface on which the activating treatment had been conducted, and an electroless copper plating process was conducted at 20°C for 20 minutes.

Thus, a conductive pattern X (plating structure X) was prepared in which a plating coating film composed of copper was formed on the surface that carries the plating nuclei thereon.

A cellophane adhesive tape (manufactured by Nichiban Co., Ltd., CT405AP-24, 24 mm) was applied onto the surface of the plating film of the conductive pattern X (plating structure X) prepared above by pressing with a finger. The cellophane adhesive tape was then peeled off in a direction at an angle of 90 degrees with respect to the surface of the conductive pattern X (plating structure X). The adhesive surface of the peeled cellophane adhesive tape was visually observed. The adhesiveness was evaluated on the basis of the presence or absence of a substance adhering to the adhesive surface of the tape.

A conductive pattern in which no substance adhered to the adhesive surface of the peeled cellophane adhesive tape was evaluated as "A". A conductive pattern in which less than about 5% of the area of any of the metal plating, silver, and the receiving layer relative to the adhering area of the adhesive tape was detached from the support and adhered to the adhesive tape was evaluated as "B". A conductive pattern in which about 5% or more and less than 50% of the area of any of the metal plating, silver, and the receiving layer relative to the adhering area of the adhesive tape was detached from the support and adhered to the adhesive tape was evaluated as "C". A conductive pattern in which about 50% or more of the area of any of the metal plating, silver, and the receiving layer relative to the adhering area of the adhesive tape was detached from the support and adhered to the adhesive tape was evaluated as "D".

### [Method for evaluating durability after electrolytic plating process]

A solvent-based plating nucleus agent 1 was prepared by dispersing silver particles (plating nuclei) having an average particle diameter of 30 nm in a mixed solvent containing 65 parts by mass of diethylene glycol diethyl ether, 18 parts by mass of γ-butyrolactone, 15 parts by mass of tetraethylene glycol dimethyl ether, and 2 parts by mass of tetraethylene glycol monobutyl ether.

Solid printing of a square region (area) having a length of 5 cm and a width of 5 cm was conducted on a surface of the receiving substrate obtained by using the support (ii) so as to have a film thickness of 0.5 µm with the plating nucleus agent 1 using an ink-jet printer (manufactured by Konica Minolta IJ Technologies, Inc., ink-jet testing device EB100, printer head for evaluation: KM512L, the amount of ejection: 42 pL). The receiving substrate was then dried at 150°C for 30 minutes to prepare printed matter. Regarding the receiving substrates described in Examples 2 to 7 and Comparative Examples 1 to 5, a cross-linked structure was formed in the receiving layer through the drying step at 150°C for 30 minutes after the printing was performed with the plating nucleus agent 1.

An activating agent (ACE CLEAN A220, manufactured by Okuno Chemical Industries Co., Ltd.) was applied onto the surface (surface on which the plating nuclei were carried) of the printed matter prepared above, and an activating treatment of the plating nuclei was conducted at 55°C for five minutes.

Subsequently, a copper sulfate plating solution (TOP LUCINA 81SW, manufactured by Okuno Chemical Industries Co., Ltd.) was applied onto the surface on which the activating treatment had been conducted, and an electrolytic plating process was conducted at 25°C, at 3 Amp, and 90 min/dm². Thus, a conductive pattern Y (plating structure Y) was prepared in which a plating coating film composed of copper was stacked on the surface of the copper plating film of the conductive pattern X (plating structure X).

A cellophane adhesive tape (manufactured by Nichiban Co., Ltd., CT405AP-24, 24 mm) was applied onto the surface of the plating film of the conductive pattern Y (plating structure Y) prepared above by pressing with a finger. The cellophane adhesive tape was then peeled off in a direction at an angle of 90 degrees with respect to the surface of the conductive pattern X (plating structure X). The adhesive surface of the peeled cellophane adhesive tape was visually observed. The adhesiveness was evaluated on the basis of the presence or absence of a substance adhering to the adhesive surface of the tape.

A conductive pattern in which no substance adhered to the adhesive surface of the peeled cellophane adhesive tape was evaluated as "A". A conductive pattern in which less than about 5% of the area of any of the metal plating, silver, and the receiving layer relative to the adhering area of the adhesive tape was detached from the support and adhered to the adhesive tape was evaluated as "B". A conductive pattern in which about 5% or more and less than 50% of the area of any of the metal plating, silver, and the receiving layer relative to the adhering area of the adhesive tape was detached from the support and adhered to the adhesive tape was evaluated as "C". A conductive pattern in which about 50% or more of the area of any of the metal plating, silver, and the receiving layer relative to the adhering area of the adhesive tape was detached from the support and adhered to the adhesive tape was evaluated as "D".

**[Table 3]**

| Table 3 | Example | | | | | | |
|---|---|---|---|---|---|---|---|
| | 1 | 2 | 3 | 4 | 5 | 6 | 7 |
| Gel fraction (after drying at 70°C, % by mass) | 70 | 69 | 75 | 73 | 61 | 55 | 50 |
| Gel fraction (after heating at 150°C, % by mass) | 80 | 100 | 100 | 100 | 99 | 97 | 97 |

**[Table 4]**

| Table 4 | Comparative Example | | | | |
|---|---|---|---|---|---|
| | 1 | 2 | 3 | 4 | 5 |
| Gel fraction (after drying at 70°C, % by mass) | 48 | 54 | 23 | 40 | 75 |
| Gel fraction (after heating at 150°C, % by mass) | 77 | 81 | 49 | 95 | 98 |

**[Table 5]**

| Table 5 | | | Example | | | | | | |
|---|---|---|---|---|---|---|---|---|---|
| | | | 1 | 2 | 3 | 4 | 5 | 6 | 7 |
| Adhesiveness between support and receiving layer | | PET | A | A | A | A | A | A | A |
| | | PI | B | A | A | B | A | B | A |
| | | GL | B | A | A | B | A | B | A |
| Fine-line-forming property | Nano-silver ink 1 for ink-jet printing | PET | A | A | B | A | A | B | A |
| | | PI | A | A | B | A | A | B | A |
| | Nano-silver ink 2 for ink-iet printing | PET | A | A | C | C | A | B | B |
| | | PI | A | A | C | C | A | B | B |
| | Nano-silver ink 3 for ink-jet printing | PET | B | B | B | B | B | B | C |
| | | PI | B | B | B | B | B | B | C |
| | Silver paste for screen printing | PET | A | A | B | B | B | B | B |
| | | PI | A | A | B | B | B | B | B |
| Electrical conduction property | Nano-silver ink 1 for ink-jet printing | PET | A | A | B | A | A | B | A |
| | | PI | A | A | B | A | A | B | A |
| | Silver paste for screen printing | PET | A | A | B | B | B | B | B |
| | | PI | A | A | B | B | B | B | B |
| Water resistance | Nano-silver ink 1 for ink-jet printing | PI | B | A | B | A | A | B | B |
| Wet-heat resistance | Nano-silver ink 1 for ink-jet printing | PI | B | A | B | A | A | B | B |
| | Nano-silver ink 2 for ink-jet printing | PI | B | A | B | B | A | B | B |
| Durability | Durability after electrolytic plating process | PI | D | A | B | A | A | B | B |
| | Durability after electroless plating process | PI | D | A | B | A | A | B | A |

**[Table 6]**

| Table 6 | | | Comparative Example | | | | |
|---|---|---|---|---|---|---|---|
| | | | 1 | 2 | 3 | 4 | 5 |
| Adhesiveness between support and receiving layer | | PET | D | D | C | D | A |
| | | PI | D | D | C | D | A |
| | | GL | D | D | C | D | A |
| Fine-line-forming property | Nano-silver ink 1 for ink-jet printing | PET | E | D | E | E | A |
| | | PI | E | D | E | E | A |
| | Nano-silver ink 2 for ink-jet printing | PET | B | E | E | E | B |
| | | PI | B | E | E | E | B |
| | Nano-silver ink 3 for ink-jet printing | PET | E | E | E | E | B |
| | | PI | E | E | E | E | B |
| | Silver paste for screen printing | PET | E | E | E | E | B |
| | | PI | E | E | E | E | B |
| Electrical conduction property | Nano-silver ink 1 for ink-jet printing | PET | E | D | E | E | A |
| | | PI | E | D | E | E | A |
| | Silver paste for screen printing | PET | E | E | E | E | B |
| | | PI | E | E | E | E | B |
| Water resistance | Nano-silver ink 1 for ink-jet printing | PI | D | D | D | C | A |
| Wet-heat resistance | Nano-silver ink 1 for ink-jet printing | PI | D | D | D | C | C |
| | Nano-silver ink 2 for ink-jet printing | PI | D | D | D | C | C |
| Durability | Durability after electrolytic plating process | PI | D | D | D | D | D |
| | Durability after electroless plating process | PI | D | D | D | D | D |

In the receiving substrate obtained in Example 1, detachment did not occur at an interface between the receiving layer and the polyethylene terephthalate substrate, polyimide substrate, or glass substrate and excellent adhesiveness was exhibited. The conductive pattern obtained in Example 1 had high water resistance, an excellent fine-line-forming property, an excellent electrical conduction property, and high wet-heat resistance.

In the receiving substrate obtained in Example 2, detachment did not occur at an interface between the receiving layer and the polyethylene terephthalate substrate, polyimide substrate, or glass substrate and excellent adhesiveness was exhibited. The conductive pattern obtained in Example 2 had high water resistance, an excellent fine-line-forming property, an excellent electrical conduction property, and high wet-heat resistance. The conductive pattern obtained in Example 2 had high durability without causing detachment or the like of the receiving layer when the plating process was conducted.

In the receiving substrate obtained in Example 3, detachment did not occur at an interface between the receiving layer and the polyethylene terephthalate substrate, polyimide substrate, or glass substrate and excellent adhesiveness was exhibited. The conductive pattern obtained in Example 3 had an excellent electrical conduction property, high water resistance, and high wet-heat resistance and also had an excellent fine-line-forming property in accordance with the type of ink. The conductive pattern obtained in Example 3 had high durability without causing detachment or the like of the receiving layer when the plating process was conducted.

In the receiving substrate described in Example 4 and including a receiving layer containing a vinyl resin having a somewhat low acid value, detachment did not occur at an interface between the receiving layer and the polyethylene terephthalate substrate, polyimide substrate, or glass substrate and excellent adhesiveness was exhibited. The conductive pattern obtained in Example 4 had an excellent electrical conduction property, high water resistance, and high wet-heat resistance and also had an excellent fine-line-forming property in accordance with the type of ink. The conductive pattern obtained in Example 4 had high durability without causing detachment or the like of the receiving layer when the plating process was conducted.

In the receiving substrate obtained in Example 5, detachment did not occur at an interface between the receiving layer and the polyethylene terephthalate substrate, polyimide substrate, or glass substrate and excellent adhesiveness was exhibited. The conductive pattern obtained in Example 5 had high water resistance, an excellent fine-line-forming property, an excellent electrical conduction property, and high wet-heat resistance. The conductive pattern obtained in Example 5 had high durability without causing detachment or the like of the receiving layer when the plating process was conducted.

In the receiving substrate described in Example 6 and including a receiving layer containing a vinyl resin having a somewhat small weight-average molecular weight, detachment did not occur at an interface between the receiving layer and the polyethylene terephthalate substrate, polyimide substrate, or glass substrate and excellent adhesiveness was exhibited. The conductive pattern obtained in Example 6 had high water resistance, an excellent fine-line-forming property, an excellent electrical conduction property, and high wet-heat resistance. The conductive pattern obtained in Example 6 had high durability without causing detachment or the like of the receiving layer when the plating process was conducted.

In the receiving substrate described in Example 7 and including a receiving layer containing a vinyl resin and a cross-linking agent in combination, detachment did not occur at an interface between the receiving layer and the polyethylene terephthalate substrate, polyimide substrate, or glass substrate and excellent adhesiveness was exhibited. The conductive pattern obtained in Example 7 had an excellent electrical conduction property, high water resistance, and high wet-heat resistance and also had an excellent fine-line-forming property in accordance with the type of ink. The conductive pattern obtained in Example 7 had high durability without causing detachment or the like of the receiving layer when the plating process was conducted.

In the receiving substrate described in Comparative Example 1 and including a receiving layer containing 66.7 parts by mass of water-soluble resin, detachment sometimes readily occurred at an interface between the receiving layer and the polyethylene terephthalate substrate, polyimide substrate, or glass substrate. The conductive pattern obtained in Comparative Example 1 was inferior in terms of a fine-line-forming property, an electrical conduction property, water resistance, and wet-heat resistance. In the conductive pattern obtained in Comparative Example 1, detachment or the like of the receiving layer sometimes occurred when the plating process was conducted.

In the receiving substrate described in Comparative Example 2 and including a receiving layer containing 66.7 parts by mass of filler, detachment sometimes readily occurred at an interface between the receiving layer and the polyethylene terephthalate substrate, polyimide substrate, or glass substrate. The conductive pattern obtained in Comparative Example 2 was inferior in terms of a fine-line-forming property, an electrical conduction property, water resistance, and wet-heat resistance. In the conductive pattern obtained in Comparative Example 2, detachment or the like of the receiving layer sometimes occurred when the plating process was conducted.

In the receiving substrate described in Comparative Example 3 and including a receiving layer containing a vinyl resin having a weight-average molecular weight of 100,000, detachment sometimes readily occurred at an interface between the receiving layer and the polyethylene terephthalate substrate, polyimide substrate, or glass substrate. The conductive pattern obtained in Comparative Example 3 was inferior in terms of a fine-line-forming property, an electrical conduction property, water resistance, and wet-heat resistance. In the conductive pattern obtained in Comparative Example 3, detachment or the like of the receiving layer sometimes occurred when the plating process was conducted.

In the receiving substrate described in Comparative Example 4 and including a receiving layer containing a vinyl resin having an acid value of 1, detachment sometimes readily occurred at an interface between the receiving layer and the polyethylene terephthalate substrate, polyimide substrate, or glass substrate. The conductive pattern obtained in Comparative Example 4 was inferior in terms of a fine-line-forming property, an electrical conduction property, water resistance, and wet-heat resistance. In the conductive pattern obtained in Comparative Example 4, detachment or the like of the receiving layer sometimes occurred when the plating process was conducted.

In the receiving substrate described in Comparative Example 5 and including a receiving layer containing a vinyl resin having an acid value of 98, excellent adhesiveness was exhibited at an interface between the receiving layer and the polyethylene terephthalate substrate, polyimide substrate, or glass substrate. The conductive pattern obtained in Comparative Example 5 had an excellent fine-line-forming property, an excellent electrical conduction property, and high water resistance, but was inferior in terms of wet-heat resistance.

## Claims

1. A resin composition for forming receiving layers, the resin composition comprising a vinyl resin (A) having a weight-average molecular weight of 100,000 or more and an acid value of 10 to 80, a water-based medium (B), and, when necessary, at least one component (C) selected from the group consisting of a water-soluble resin (c1) and a filler (c2), wherein the vinyl resin (A) is dispersed in the water-based medium (B) and a content of the component (C) is 0% by mass to 15% by mass relative to the total amount of the vinyl resin (A).

2. The resin composition for forming receiving layers according to Claim 1, wherein the resin composition for forming receiving layers is used to form a layer that receives a fluid containing a conductive substance.

3. The resin composition for forming receiving layers according to Claim 2, wherein the fluid containing a conductive substance is a conductive ink containing a conductive substance or a plating nucleus agent containing a conductive substance.

4. The resin composition for forming receiving layers according to Claim 1, wherein the vinyl resin (A) is obtained by polymerizing a vinyl monomer mixture, and the vinyl monomer mixture contains 0.2% by mass to 15% by mass of a vinyl monomer having an acid group relative to the total amount of the vinyl monomer mixture.

5. The resin composition for forming receiving layers according to Claim 1, wherein the vinyl resin (A) is obtained by polymerizing a vinyl monomer mixture, and the vinyl monomer mixture contains 0.2% by mass to 15% by mass of a vinyl monomer having an acid group, 0.01% by mass to 80% by mass of methyl methacrylate, and 5% by mass to 60% by mass of a (meth)acrylic acid alkyl ester having an alkyl group with 2 to 12 carbon atoms relative to the total amount of the vinyl monomer mixture.

6. The resin composition for forming receiving layers according to Claim 1, wherein the vinyl resin (A) has a cross-linkable functional group.

7. The resin composition for forming receiving layers according to Claim 6, wherein the cross-linkable functional group is at least one thermal cross-linkable functional group selected from the group consisting of a methylolamide group and an alkoxymethylamide group.

8. The resin composition for forming receiving layers according to any one of Claims 1 to 6, further comprising a cross-linking agent (D), wherein the cross-linking agent (D) causes a cross-linking reaction by performing heating to 100°C or more.

9. The resin composition for forming receiving layers according to Claim 8, wherein the cross-linking agent (D) is at least one thermal cross-linking agent (d1-2) selected from the group consisting of a melamine compound, an epoxy compound, an oxazoline compound, a carbodiimide compound, and an isocyanate compound.

10. A receiving substrate comprising a receiving layer formed on part or the entirety of a surface of a support using the resin composition for forming receiving layers according to any one of Claims 1 to 9, wherein the receiving layer is a receiving layer for receiving a fluid containing a conductive substance.

11. Printed matter produced by performing printing on the receiving layer constituting the receiving substrate according to Claim 10 with the fluid containing a conductive substance.

12. The printed matter according to Claim 11, wherein the printing is performed by an ink-jet printing method, a screen printing method, a letterpress reverse printing method, or a gravure off-set printing method.

13. A conductive pattern produced by performing printing on the receiving layer constituting the receiving substrate according to Claim 10 with a fluid that is a conductive ink containing a conductive substance or a plating nucleus agent containing a metal serving as a conductive substance.

14. A conductive pattern produced by performing printing on the receiving substrate according to Claim 10 with a fluid that is a conductive ink containing a conductive substance or a plating nucleus agent containing a conductive substance, and then forming a cross-linked structure in the receiving layer on which the printing has been performed.

15. The conductive pattern according to Claim 13 or 14 produced by performing an electrolytic plating process or an electroless plating process on a surface of a printed portion formed by performing the printing with the fluid.

16. A conductive pattern produced by performing an electrolytic plating process on a surface of a printed portion formed by performing printing with the fluid that constitutes the conductive pattern according to Claim 13 or 14.

17. An electric circuit formed of the conductive pattern according to any one of Claims 13 to 16.

18. A method for producing printed matter comprising applying the resin composition for forming receiving layers according to any one of Claims 1 to 9 onto part or the entirety of a surface of a support and drying the resin composition for forming receiving layers under conditions under which the resin composition does not undergo a cross-linking reaction to form a receiving layer for receiving a fluid containing a conductive substance; then performing printing on a surface of the receiving layer with the fluid containing a conductive substance; and then heating the receiving layer, on which the printing has been performed, to form a cross-linked structure.

19. A method for producing a conductive pattern comprising applying the resin composition for forming receiving layers according to any one of Claims 1 to 9 onto part or the entirety of a surface of a support and drying the resin composition for forming receiving layers under conditions under which the resin composition does not undergo a cross-linking reaction to form a receiving layer for receiving a fluid containing a conductive substance; then performing printing on a surface of the receiving layer with the fluid containing a conductive substance to form a printed portion composed of the conductive substance that is contained in the fluid; then heating the receiving layer, on which the printing has been performed, to form a cross-linked structure; and then performing a plating process on the printed portion formed on the surface of the receiving layer.
